# EUROPEAN PATENT APPLICATION

(11) **EP 4 231 490 A1**
(43) Date of publication of application: **23.08.2023**
(21) Application number: 23156896.5
(22) Date of filing: 15.02.2023
(51) Int. Cl.: H02J 7/00, H02J 50/00, H02J 50/10, H02J 50/90, H04B 5/00

(54) **WIRELESS CHARGING MODULE, ELECTRONIC DEVICE, AND CHARGER**

(30) Priority: 17.02.2022 CN 202210147881
(71) Applicant: Huawei Digital Power Technologies Co., Ltd., Shenzhen, 518043 (CN)
(72) Inventor: LI, Yuechao, 518043 Shenzhen (CN); WANG, Chao, 518043 Shenzhen (CN); WU, Baoshan, 518043 Shenzhen (CN); LI, Changyuan, 518043 Shenzhen (CN)
(74) Representative: Gill Jennings & Every LLP

(57) **Abstract**

This application provides a wireless charging module, an electronic device, and a charger. The wireless charging module includes a charging coil and a magnetic alignment apparatus. The magnetic alignment apparatus includes a first permanent magnet and a second permanent magnet. The first permanent magnet and the second permanent magnet are disposed adjacently on one surface. The charging coil is disposed on an inner side or an outer side of the magnetic alignment apparatus. Magnetization manners for the first permanent magnet and the second permanent magnet are different. Magnetic field strength on an upper side and a lower side of the magnetic alignment apparatus is different. The wireless charging module provided in this application can not only reduce impact on another magnetically sensitive device in the charger or the electronic device, but also enhance a magnetic attraction force between the electronic device and the charger.

## Description

### TECHNICAL FIELD

The present invention relates to the field of charging technologies, and in particular, to a wireless charging module, an electronic device, and a charger.

### BACKGROUND

In a conventional wireless charging technology, an electronic device and a charger may be attracted to each other by using a magnet, and wireless charging is implemented between the electronic device and a charging coil of the charger through electromagnetic induction. However, a magnetic field of the magnet affects normal operation of other magnetic field-sensitive devices in the electronic device and the charger, affecting performance of the electronic device and the charger.

### SUMMARY

To resolve the foregoing problem, embodiments of this application provide a wireless charging module, and an electronic device and a charger in which the wireless charging module is used. The wireless charging module includes a charging coil and a magnetic alignment apparatus, where magnetic field strength on an upper side and a lower side of the magnetic alignment apparatus is different. Magnetic field strength on one side of the magnetic alignment apparatus is reduced, so that impact of the magnetic alignment apparatus on a magnetically sensitive device in the charger or the electronic device can be reduced, and soft magnetic materials can be omitted or reduced, thereby facilitating heat dissipation and miniaturization of the charger or the electronic device. Magnetic field strength on one side of the magnetic alignment apparatus is enhanced, so that a magnetic attraction force between the electronic device and the charger can be enhanced, thereby helping improve user experience of the electronic device and the charger.

In view of this, the following technical solutions are used in embodiments of this application.

According to a first aspect, this application provides a wireless charging module, including a charging coil and a magnetic alignment apparatus. The magnetic alignment apparatus includes a first permanent magnet and a second permanent magnet. The first permanent magnet and the second permanent magnet are disposed adjacently on one surface. Magnetization manners for the first permanent magnet and the second permanent magnet are different. Magnetic field strength on an upper side and a lower side of the magnetic alignment apparatus is different. The charging coil is configured to receive or transmit electricity. The charging coil is disposed on an inner side or an outer side of the magnetic alignment apparatus.

In an embodiment, the charging coil is disposed on an inner side of the first permanent magnet of the magnetic alignment apparatus, or the charging coil is disposed on an outer side of the second permanent magnet of the magnetic alignment apparatus.

In an embodiment, a magnetic field direction in the first permanent magnet is perpendicular to the surface, and a magnetic field direction in the second permanent magnet is parallel to the surface; or a magnetic field direction in the first permanent magnet is parallel to the surface, and a magnetic field direction in the second permanent magnet is perpendicular to the surface.

In an embodiment, the first permanent magnet is an axially magnetized permanent magnet, and the second permanent magnet is a radially magnetized permanent magnet; or the first permanent magnet is a radially magnetized permanent magnet, and the second permanent magnet is an axially magnetized permanent magnet.

In the magnetic alignment apparatus of the wireless charging module, the internal magnetic field directions of the two permanent magnets are perpendicular to each other. This not only can enhance magnetic field strength on one side of the magnetic alignment apparatus, but also can reduce magnetic field strength on the other side of the magnetic alignment apparatus, thereby reducing impact of the magnetic alignment apparatus on a magnetic field-sensitive device in the charger or the electronic device. In addition, soft magnetic materials can be omitted or reduced, thereby facilitating heat dissipation and miniaturization of the charger or the electronic device.

In an embodiment, the magnetic alignment apparatus includes a third permanent magnet. The third permanent magnet and the second permanent magnet are disposed adjacently on one surface. A magnetization manner for the third permanent magnet is the same as a magnetization manner for the first permanent magnet. A magnetic field direction in the third permanent magnet is opposite to a magnetic field direction in the first permanent magnet.

In an embodiment, the charging coil is disposed on an inner side of the first permanent magnet of the magnetic alignment apparatus, or the charging coil is disposed on an outer side of the third permanent magnet of the magnetic alignment apparatus.

In the magnetic alignment apparatus of the wireless charging module, the third permanent magnet is disposed on an outer side of the second permanent magnet, and a magnetic field of the third permanent magnet forms a loop with magnetic fields of the first permanent magnet and the second permanent magnet. This not only can enhance magnetic field strength on one side of the magnetic alignment apparatus, but also can reduce magnetic field strength on the other side of the magnetic alignment apparatus and around the magnetic alignment apparatus, thereby reducing impact of the magnetic alignment apparatus on a magnetic field-sensitive device in the charger or the electronic device. In addition, soft magnetic materials are omitted or reduced, thereby facilitating heat dissipation and miniaturization of the charger or the electronic device.

In an embodiment, a top-view cross-sectional shape of the first permanent magnet is one of a circular shape, a ring shape, an arc shape, or a polygonal shape, and a top-view cross-sectional shape of the second permanent magnet is one of a ring shape, an arc shape, or a polygonal shape.

In an embodiment, an inner longitudinal size of the second permanent magnet is greater than or equal to an outer longitudinal size of the first permanent magnet. The second permanent magnet is disposed on an inner side of the first permanent magnet.

In an embodiment, a top-view cross-sectional shape of the third permanent magnet is one of a ring shape, an arc shape, or a polygonal shape.

In an implementation, an inner longitudinal size of the third permanent magnet is greater than or equal to an outer longitudinal size of the second permanent magnet. The third permanent magnet is disposed on an outer side of the second permanent magnet.

In an embodiment, the first permanent magnet, the second permanent magnet, or the third permanent magnet includes one or more permanent magnet modules.

In an embodiment, a top-view cross-sectional shape of the permanent magnet module is one of a ring shape, an arc shape, or a polygonal shape.

In an embodiment, a plurality of permanent magnet modules in one permanent magnet may be spliced into a ring shape, an arc shape, or a polygonal shape.

In an embodiment, magnetic field directions in two adjacent permanent magnet modules in one permanent magnet are opposite.

In an embodiment, a plurality of permanent magnet modules in one permanent magnet include at least two sides, and a magnetic field direction in a plurality of permanent magnet modules on one side of two adjacent sides is opposite to a magnetic field direction in a plurality of permanent magnet modules on the other side.

In the magnetic alignment apparatus of the wireless charging module, a shape of the permanent magnet or the permanent magnet module may be selected based on space of the electronic device or the charger, thereby improving applicability of the magnetic alignment apparatus. Magnetic field directions in two adjacent permanent magnet modules or permanent magnet modules on two adjacent sides in one permanent magnet are opposite. This can reduce a repulsive force between permanent magnet modules when the magnetic alignment apparatus is assembled, thereby facilitating assembly of the magnetic alignment apparatus.

According to a second aspect, this application provides an electronic device, including a power module and the foregoing wireless charging module. A charging coil of the wireless charging module is electrically connected to the power module. The charging coil of the wireless charging module is configured to receive electric energy transmitted by the charging coil of a charger. Magnetic field strength on an upper side of a magnetic alignment apparatus is weaker than magnetic field strength on a lower side of the magnetic alignment apparatus. The magnetic alignment apparatus is configured to limit a contact location between the electronic device and the charger, so that the charging coil of the charger matches the charging coil of the electronic device.

According to a third aspect, this application provides a charger, including a charging coil and the foregoing wireless charging module. A charging coil of the wireless charging module is electrically connected to the power module. The charging coil of the wireless charging module is configured to transmit electric energy to a charging coil of an electronic device. Magnetic field strength on an upper side of a magnetic alignment apparatus is stronger than magnetic field strength on a lower side of the magnetic alignment apparatus. The magnetic alignment apparatus is configured to limit a contact location between the charger and the electronic device, so that the charging coil of the charger matches the charging coil of the electronic device.

Magnetic field strength on an upper side of the electronic device or a lower side of the charger is reduced, so that impact of a magnetic field of the magnetic alignment apparatus in the wireless charging module on a magnetic field-sensitive device in the electronic device or the charger can be reduced. Magnetic field strength on a lower side of the electronic device or an upper side of the charger is enhanced, so that a magnetic attraction force between the electronic device and the charger can be enhanced, and a contact location between the charger and the electronic device can be better limited, thereby facilitating matching between the charging coil of the electronic device and the charging coil of the charger, and improving user experience of the electronic device or the charger.

### BRIEF DESCRIPTION OF DRAWINGS

The following briefly describes accompanying drawings required for describing embodiments or a conventional technology.
FIG. 1(a) is a schematic diagram of a structure of an electronic device and a charger thereof in a conventional technology;
FIG. 1(b) is a schematic diagram of a permanent magnet according to an embodiment of this application;
FIG. 1(c) is a schematic diagram of another permanent magnet according to an embodiment of this application;
FIG. 1(d) is a schematic diagram of another permanent magnet according to an embodiment of this application;
FIG. 1(e) is a schematic diagram of another permanent magnet according to an embodiment of this application;
FIG. 2 is a schematic diagram of a structure of an electronic device and a charger thereof according to an embodiment of this application;
FIG. 3 is a schematic diagram of a structure of a magnetic alignment apparatus according to an embodiment of this application;
FIG. 4(a) is a schematic diagram of magnetic fields of permanent magnets of a magnetic alignment apparatus according to an embodiment of this application;
FIG. 4(b) is a schematic diagram of a structure of another electronic device and a charger thereof according to an embodiment of this application;
FIG. 5 is a schematic diagram of a structure of another magnetic alignment apparatus according to an embodiment of this application;
FIG. 6 is a schematic diagram of magnetic fields of permanent magnets of another magnetic alignment apparatus according to an embodiment of this application;
FIG. 7 is a schematic diagram of a structure of another magnetic alignment apparatus according to an embodiment of this application;
FIG. 8 is a schematic diagram of magnetic fields of permanent magnets of another magnetic alignment apparatus according to an embodiment of this application;
FIG. 9 is a schematic diagram of a structure of another magnetic alignment apparatus according to an embodiment of this application;
FIG. 10 is a schematic diagram of magnetic fields of permanent magnets of another magnetic alignment apparatus according to an embodiment of this application;
FIG. 11 is a schematic diagram of magnetic fields of permanent magnets of another magnetic alignment apparatus according to an embodiment of this application;
FIG. 12 is a schematic diagram of a structure of another magnetic alignment apparatus according to an embodiment of this application;
FIG. 13 is a schematic diagram of a structure of another magnetic alignment apparatus according to an embodiment of this application;
FIG. 14 is a schematic diagram of magnetic fields of permanent magnets of another magnetic alignment apparatus according to an embodiment of this application;
FIG. 15 is a schematic diagram of a structure of a permanent magnet of a magnetic alignment apparatus according to an embodiment of this application;
FIG. 16 is a schematic diagram of a structure of a permanent magnet of another magnetic alignment apparatus according to an embodiment of this application;
FIG. 17 is a schematic diagram of magnetic fields of permanent magnets of another magnetic alignment apparatus according to an embodiment of this application;
FIG. 18 is a schematic diagram of a top-view cross-section of a wireless charging module according to an embodiment of this application;
FIG. 19 is a schematic diagram of a top-view cross-section of another wireless charging module according to an embodiment of this application; and
FIG. 20 is a schematic diagram of a top-view cross-section of another wireless charging module according to an embodiment of this application.

### DESCRIPTION OF EMBODIMENTS

The following describes technical solutions in embodiments of this application with reference to the accompanying drawings in embodiments of this application.

In descriptions of this application, directions or location relationships indicated by terms such as "center", "up", "down", "front", "rear", "left", "right", "vertical", "horizontal", "top", "bottom", "inside", and "outside" are based on directions or location relationships shown in accompanying drawings, and are merely intended to describe this application and simplify descriptions, but not to indicate or imply that an indicated apparatus or component needs to have a specific direction or be formed or operated in a specific direction, and therefore cannot be construed as a limitation on this application.

In descriptions of this application, it should be noted that terms "mounted", "connected to", and "connection" should be understood in a broad sense, for example, may be a fixed connection, a detachable connection, a contact connection, or an integrated connection, unless otherwise clearly specified and limited. Persons of ordinary skill in the art may understand specific meanings of the foregoing terms in this application based on specific situations.

In the descriptions of this specification, the described specific features, structures, materials, or characteristics may be combined in a proper manner in any one or more of embodiments or examples.

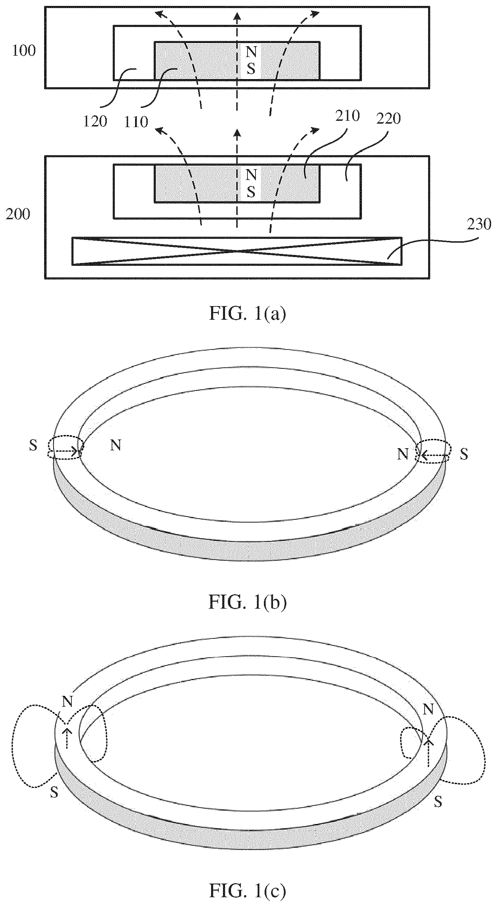

FIG. 1(a) is a schematic diagram of a structure of an electronic device and a charger thereof in a conventional technology. As shown in FIG. 1(a), the charger 200 is horizontally placed on a desktop, the electronic device 100 is stacked on the charger 200, and wireless charging may be performed after a charging coil of the electronic device 100 matches a charging coil of the charger 200. The electronic device 100 includes a magnet 110 and a soft magnetic material 120. The soft magnetic material 120 wraps around and on an upper side of the magnet 110. The charger 200 includes a magnet 210, a soft magnetic material 220, and a fan 230. The soft magnetic material 220 wraps around and on a lower side of the magnet 210, and the fan 230 is disposed under the soft magnetic material 220.

In the conventional electronic device or charger, the soft magnetic material wraps around and on one side of the magnet, and the soft magnetic material is used to absorb a magnetic field of the magnet, to reduce impact of the magnet on a magnetic field-sensitive device in the electronic device or the charger. However, the soft magnetic material has a limited magnetic absorption capability, and cannot eliminate impact of a magnetic field of the magnet on the magnetic field-sensitive device. In addition, the soft magnetic material wraps around and on one side of the magnet, affecting heat dissipation of the electronic device or the charger. In addition, the soft magnetic material needs to occupy internal space of the electronic device or the charger, affecting miniaturization of the electronic device or the charger.

To resolve problems in a conventional wireless charging technology, embodiments of this application provide a wireless charging module, and an electronic device and a charger in which the wireless charging module is used.

The wireless charging module provided in embodiments of this application includes a charging coil and a magnetic alignment apparatus, where magnetic field strength on two sides of the magnetic alignment apparatus is different. Magnetic field strength on one side of the magnetic alignment apparatus is reduced, so that impact of the magnetic alignment apparatus on another magnetically sensitive device in the charger or the electronic device can be reduced, and soft magnetic materials can be omitted or reduced, thereby facilitating heat dissipation and miniaturization of the charger or the electronic device. Magnetic field strength on one side of the magnetic alignment apparatus is enhanced, so that a magnetic attraction force between the electronic device and the charger can be enhanced, and a contact location between the electronic device and the charger can be better limited, thereby facilitating matching between charging coils of the electronic device and the charger, and improving user experience of the electronic device and the charger during wireless charging.

The electronic device provided in embodiments of this application includes a power module and a wireless charging module. The power module is configured to supply power to the electronic device. The wireless charging module includes a charging coil and a magnetic alignment apparatus. The charging coil of the wireless charging module is electrically connected to the power module. The charging coil of the wireless charging module is configured to receive electric energy transmitted by a charging coil of the charger. The wireless charging module is disposed on a lower side in the electronic device. Magnetic field strength on an upper side of the magnetic alignment apparatus is weaker than magnetic field strength on a lower side of the magnetic alignment apparatus. The magnetic alignment apparatus is configured to limit a contact location between the electronic device and the charger, so that the charging coil of the electronic device matches the charging coil of the charger.

The charger provided in embodiments of this application includes a power module and a wireless charging module. The wireless charging module includes a charging coil and a magnetic alignment apparatus. The charging coil of the wireless charging module is electrically connected to the power module. The power module is configured to supply power to the charging coil of the wireless charging module. The charging coil of the wireless charging module is configured to transmit electric energy to the charging coil of the electronic device. The wireless charging module is disposed on an upper side in the charger. Magnetic field strength on an upper side of the magnetic alignment apparatus is stronger than magnetic field strength on a lower side of the magnetic alignment apparatus. The magnetic alignment apparatus is configured to limit a contact location between the charger and the electronic device, so that the charging coil of the charger matches the charging coil of the electronic device.

In embodiments of this application, a "longitudinal size of a permanent magnet" refers to a distance between a center of a permanent magnet in a circular shape, a ring shape, an arc shape, or a polygonal shape and an inner edge or an outer edge. A "surface" may be a substrate, in the electronic device or the charger, that is used to carry the magnetic alignment apparatus; may be a housing of the electronic device or the charger; or may be a substrate, in the electronic device or the charger, that is used to carry the charging coil. In embodiments of this application, the surface may be a plane or a curved surface. In embodiments of this application, the substrate may be a circuit board, a soft magnetic material, or a mechanical part. "Upward" indicates a direction from the charger 200 to the electronic device 100 during wireless charging. "Downward" indicates a direction opposite to "upward". During wireless charging, a side, of the electronic device 100, that is close to the charger 200 is a lower side of the electronic device 100, and the other side of the electronic device 100 is an upper side of the electronic device 100. During wireless charging, a side, of the charger 200, that is close to the electronic device 100 is an upper side of the charger 200, and the other side of the charger 200 is a lower side of the charger 200.

In embodiments of this application, the magnetic alignment apparatus of the wireless charging module includes a plurality of permanent magnets. Through differentiation based on a top-view cross-sectional shape, a top-view cross-sectional shape of the permanent magnet includes a circular shape, a ring shape, an arc shape, or a polygonal shape. The ring shape includes a circular ring shape, a polygonal ring shape, or another ring shape. The polygonal shape includes a triangular shape, a quadrangular shape, or another polygonal shape. Through differentiation based on magnetization manners for the permanent magnets, the permanent magnet includes a radially magnetized permanent magnet, an axially magnetized permanent magnet, or a longitudinally magnetized permanent magnet. In embodiments of this application, a material of the permanent magnet includes a magnetic material, for example, a neodymium iron boron magnet or a neodymium magnet. Materials of the plurality of permanent magnets may be the same or different.

In embodiments of this application, the magnetization manner, the top-view cross-sectional shape, and an internal magnetic field direction of the permanent magnet may include a plurality of combinations. A magnetization manner for a permanent magnet in a circular shape, a ring shape, an arc shape, or a polygonal shape may include radial magnetization or axial magnetization. A magnetization manner for a permanent magnet in a polygonal shape may alternatively include axial magnetization or radial magnetization. In embodiments of this application, "a magnetic field direction in a permanent magnet" is a direction of an S pole pointing to an N pole in the permanent magnet.

For example, FIG. 1(b) shows a ring-shaped radially magnetized permanent magnet. The ring-shaped radially magnetized permanent magnet is placed horizontally on a plane. A magnetic field direction in the ring-shaped radially magnetized permanent magnet is approximately parallel to the plane. The magnetic field direction in the ring-shaped radially magnetized permanent magnet points from an outer side to a center. In another embodiment, the magnetic field direction in the ring-shaped radially magnetized permanent magnet may point from the center to the outer side.

For example, FIG. 1(c) shows a ring-shaped axially magnetized permanent magnet. The ring-shaped axially magnetized permanent magnet is placed horizontally on a plane. A magnetic field direction in the ring-shaped axially magnetized permanent magnet is approximately perpendicular to the plane. The magnetic field direction in the ring-shaped axially magnetized permanent magnet points from a lower side to an upper side. In another embodiment, the magnetic field direction in the ring-shaped axially magnetized permanent magnet may point from the upper side to the lower side.

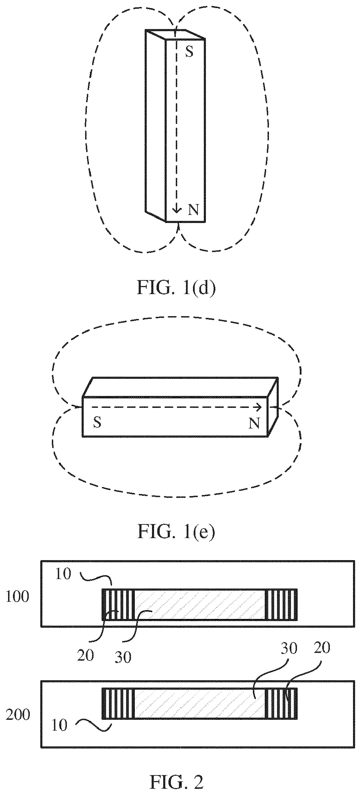

For example, FIG. 1(d) shows a rectangular axially magnetized permanent magnet. The rectangular axially magnetized permanent magnet is placed horizontally on a plane. A magnetic field direction in the rectangular axially magnetized permanent magnet is approximately perpendicular to the plane. The magnetic field direction in the rectangular axially magnetized permanent magnet points from an upper side to a lower side. In another embodiment, the magnetic field direction in the rectangular axially magnetized permanent magnet may point from the lower side to the upper side.

For example, FIG. 1(e) shows a rectangular radially magnetized permanent magnet. The rectangular radially magnetized permanent magnet is placed horizontally on a plane. A magnetic field direction in the rectangular radially magnetized permanent magnet is approximately parallel to the plane. The magnetic field direction in the rectangular radially magnetized permanent magnet points from a left side to a right side. In another embodiment, the magnetic field direction in the rectangular radially magnetized permanent magnet may be any direction approximately parallel to the plane, for example, pointing from the right side to the left side, pointing from a front side to a rear side, or pointing from the rear side to the front side.

FIG. 2 is a schematic diagram of a structure of an electronic device 100 and a charger 200 thereof according to an embodiment of this application. The electronic device 100 may be a watch, a mobile phone, a headset, a tablet computer, a computer, or the like. The charger 200 may be a portable charger, a vehicle-mounted charger, or the like. For ease of description of a wireless charging module 10 of the electronic device 100 or the charger 200, other circuits or structures of the electronic device 100 and the charger 200 are omitted in FIG. 2.

As shown in FIG. 2, the electronic device 100 includes a wireless charging module 10. The wireless charging module 10 is disposed on a lower surface in the electronic device 100. In an embodiment, the wireless charging module 10 is disposed on an inner surface of a housing on a lower side of the electronic device 100, or on a substrate in the electronic device 100. That is, the surface may be the inner surface of the housing on the lower side of the electronic device 100 or the substrate in the electronic device 100. The wireless charging module 10 includes a charging coil 20 and a magnetic alignment apparatus 30. In the electronic device 100, magnetic field strength on a lower side of the magnetic alignment apparatus 30 is stronger than magnetic field strength on an upper side of the magnetic alignment apparatus 30.

As shown in FIG. 2, the charger 200 includes a wireless charging module 10. The wireless charging module 10 is disposed on an upper surface in the charger 200. In an embodiment, the wireless charging module 10 is disposed on an inner surface of a housing on an upper side of the charger 200, or on a substrate in the charger 200. That is, the surface may be the inner surface of the housing on the upper side of the charger 200 or the substrate in the charger 200. The wireless charging module 10 includes a charging coil 20 and a magnetic alignment apparatus 30. In the charger 200, magnetic field strength on an upper side of the magnetic alignment apparatus 30 is stronger than magnetic field strength on a lower side of the magnetic alignment apparatus 30.

As shown in FIG. 2, the charging coil 20 and the magnetic alignment apparatus 30 in the wireless charging module 10 are disposed on one surface. In another embodiment, the charging coil 20 and the magnetic alignment apparatus 30 of the wireless charging module 10 each may be provided with a plurality of surfaces, and a surface of the charging coil 20 are parallel to or close to a surface of the magnetic alignment apparatus 30.

As shown in FIG. 2, the charging coil 20 in the wireless charging module 10 is disposed on an outer side of the magnetic alignment apparatus 30. In another embodiment, the charging coil 20 in the wireless charging module 10 may be disposed on an inner side of the magnetic alignment apparatus 30.

Soft magnetic materials may be omitted or reduced in the electronic device 100 or the charger 200 provided in this embodiment of this application, thereby facilitating heat dissipation and miniaturization of the electronic device 100 or the charger 200. In addition, a magnetic attraction force between the lower side of the electronic device 100 and the upper side of the charger 200 is enhanced, so that a contact location between the electronic device 100 and the charger 200 can be better limited, thereby facilitating matching between the charging coil 20 of the electronic device 100 and the charging coil 20 of the charger 200, and improving user experience of the electronic device 100 or the charger 200.

The wireless charging module 10 in the electronic device 100 or the charger 200 shown in FIG. 2 has a plurality of embodiments. The magnetic alignment apparatus 30 in the wireless charging module 10 includes a plurality of permanent magnets, and a location relationship, a quantity, a magnetization manner, a top-view cross-sectional shape, an internal magnetic field direction, a structure, and the like of the plurality of permanent magnets may have a plurality of combinations.

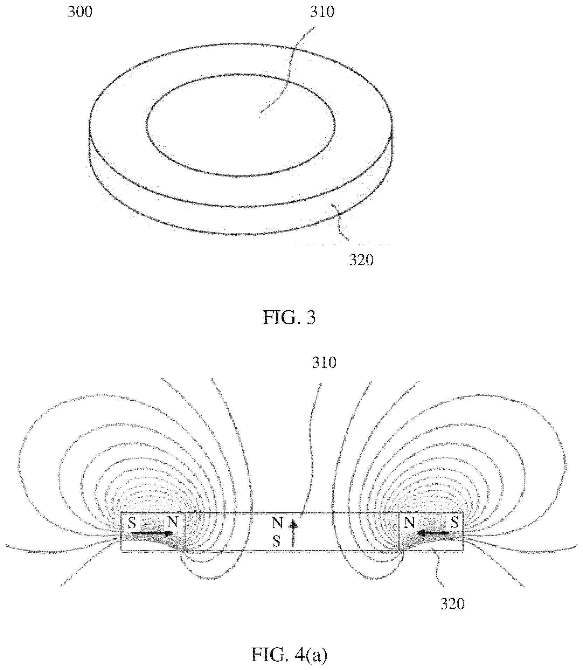

FIG. 3 is a schematic diagram of a structure of a magnetic alignment apparatus according to an embodiment of this application. As shown in FIG. 3, the magnetic alignment apparatus 300 includes an axially magnetized permanent magnet 310 and a radially magnetized permanent magnet 320. The axially magnetized permanent magnet 310 and the radially magnetized permanent magnet 320 are disposed adjacently on one surface. The axially magnetized permanent magnet 310 is in a cylindrical structure, and a top-view cross-sectional shape of the axially magnetized permanent magnet 310 is a circular shape. The radially magnetized permanent magnet 320 is in a ring-shaped cylindrical structure, and a top-view cross-sectional shape of the radially magnetized permanent magnet 320 is a circular ring shape. An inner longitudinal size of the radially magnetized permanent magnet 320 is greater than or equal to a longitudinal size of the axially magnetized permanent magnet 310. The axially magnetized permanent magnet 310 is disposed on an inner side of the radially magnetized permanent magnet 320. In an embodiment, the axially magnetized permanent magnet 310 and the radially magnetized permanent magnet 320 may be fastened to form an integrated structure. In another embodiment, the axially magnetized permanent magnet 310 and the radially magnetized permanent magnet 320 may be separately fastened to one surface, and there may be a gap between the axially magnetized permanent magnet 310 and the radially magnetized permanent magnet 320.

As shown in FIG. 3, a top-view cross-sectional shape of the axially magnetized permanent magnet 310 is a circular shape, and a top-view cross-sectional shape of the radially magnetized permanent magnet 320 is a circular ring shape. A magnetic field of a permanent magnet in a circular shape or a circular ring shape is uniformly distributed, thereby facilitating mutual weakening and enhancement of a magnetic field of the axially magnetized permanent magnet 310 and a magnetic field of the radially magnetized permanent magnet 320. In some embodiments, a top-view cross-sectional shape of the axially magnetized permanent magnet 310 may be an elliptic shape, and a top-view cross-sectional shape of the radially magnetized permanent magnet 320 may be an elliptic ring shape. In some embodiments, a top-view cross-sectional shape of the axially magnetized permanent magnet 310 may be a polygonal shape such as a triangular shape or a quadrangular shape, or another irregular shape, and a top-view cross-sectional shape of the radially magnetized permanent magnet 320 may be a polygonal ring shape such as a triangular ring shape or a quadrangular ring shape, or another irregular ring shape. In this embodiment of this application, based on internal space of the electronic device 100 or the charger 200, any one of the foregoing axially magnetized permanent magnets 310 or radially magnetized permanent magnets 320 may be selected for the magnetic alignment apparatus 300, thereby improving applicability of the magnetic alignment apparatus 300.

FIG. 4(a) is a schematic diagram of magnetic fields of permanent magnets of a magnetic alignment apparatus according to an embodiment of this application. As shown in FIG. 4(a), the magnetic alignment apparatus 300 includes an axially magnetized permanent magnet 310 and a radially magnetized permanent magnet 320. An N pole of the axially magnetized permanent magnet 310 faces upward, and an S pole faces downward. An N pole of the radially magnetized permanent magnet 320 faces an inner side of a circular ring, and an S pole faces an outer side of the circular ring. Correspondingly, magnetic fields of the axially magnetized permanent magnet 310 and the radially magnetized permanent magnet 320 are mutually enhanced on an upper side of the magnetic alignment apparatus 300, thereby enhancing magnetic field strength on the upper side of the magnetic alignment apparatus 300. The magnetic fields of the axially magnetized permanent magnet 310 and the radially magnetized permanent magnet 320 are mutually weakened on a lower side of the magnetic alignment apparatus 300, thereby reducing magnetic field strength on the lower side of the magnetic alignment apparatus 300.

Internal magnetic field directions of the axially magnetized permanent magnet 310 and the radially magnetized permanent magnet 320 of the magnetic alignment apparatus 300 alternatively include another combination, to enhance the magnetic field strength on the upper side of the magnetic alignment apparatus 300 and reduce the magnetic field strength on the lower side of the magnetic alignment apparatus 300. For example, an S pole of the axially magnetized permanent magnet 310 faces upward, and an N pole faces downward. An S pole of the radially magnetized permanent magnet 320 faces an inner side of a circular ring, and an N pole faces an outer side of the circular ring. Correspondingly, magnetic fields of the axially magnetized permanent magnet 310 and the radially magnetized permanent magnet 320 are mutually enhanced on an upper side of the magnetic alignment apparatus 300, thereby enhancing magnetic field strength on the upper side of the magnetic alignment apparatus 300. The magnetic fields of the axially magnetized permanent magnet 310 and the radially magnetized permanent magnet 320 are mutually weakened on a lower side of the magnetic alignment apparatus 300, thereby reducing magnetic field strength on the lower side of the magnetic alignment apparatus 300.

In an embodiment, a magnetic field direction in the axially magnetized permanent magnet 310 is perpendicular to a surface, a magnetic field direction in the radially magnetized permanent magnet 320 is parallel to the surface, and the magnetic field direction in the axially magnetized permanent magnet 310 is perpendicular to the magnetic field direction in the radially magnetized permanent magnet 320. That is, an included angle between the magnetic field direction in the axially magnetized permanent magnet 310 and the surface is 90 degrees, an included angle between the magnetic field direction in the radially magnetized permanent magnet 320 and the surface is 0 degrees, and an included angle between the magnetic field direction in the axially magnetized permanent magnet 310 and the magnetic field direction in the radially magnetized permanent magnet 320 is 90 degrees. In another embodiment, an included angle between the magnetic field direction in the axially magnetized permanent magnet 310 and the surface may be less than 90 degrees, or an included angle between the magnetic field direction in the radially magnetized permanent magnet 320 and the surface may be less than 0 degrees, or an included angle between the magnetic field direction in the axially magnetized permanent magnet 310 and the magnetic field direction in the radially magnetized permanent magnet 320 may be less than 90 degrees.

In the magnetic alignment apparatus 300 in this embodiment of this application, magnetic field strength on an upper side can also be reduced, and magnetic field strength on a lower side can also be enhanced. In an embodiment, an S pole of the axially magnetized permanent magnet 310 faces upward, and an N pole faces downward. An S pole of the radially magnetized permanent magnet 320 faces an outer side of a circular ring, and an N pole faces an inner side of the circular ring. In an embodiment, an N pole of the axially magnetized permanent magnet 310 faces upward, and an S pole faces downward. An S pole of the radially magnetized permanent magnet 320 faces an inner side of a circular ring, and an N pole faces an outer side of the circular ring. Correspondingly, magnetic fields of the axially magnetized permanent magnet 310 and the radially magnetized permanent magnet 320 are mutually weakened on an upper side of the magnetic alignment apparatus 300, thereby reducing magnetic field strength on the upper side of the magnetic alignment apparatus 300. The magnetic fields of the axially magnetized permanent magnet 310 and the radially magnetized permanent magnet 320 are mutually enhanced on a lower side of the magnetic alignment apparatus 300, thereby enhancing magnetic field strength on the lower side of the magnetic alignment apparatus 300.

It can be understood that the upper side and the lower side of the magnetic alignment apparatus 300 are symmetrical. That is, magnetic field strength on one side of the magnetic alignment apparatus 300 is enhanced, and magnetic field strength on the other side of the magnetic alignment apparatus 300 is reduced. The magnetic field strength on the one side of the magnetic alignment apparatus 300 is different from the magnetic field strength on the other side of the magnetic alignment apparatus 300. The magnetic field strength on the one side of the magnetic alignment apparatus 300 is stronger than the magnetic field strength on the other side of the magnetic alignment apparatus 300.

Optionally, the magnetic alignment apparatus 300 may further include a magnetic conducting assembly. The magnetic conducting assembly may include a soft magnetic material. In an embodiment, a top-view cross-sectional shape of the magnetic conducting assembly is a circular ring shape or a polygonal ring shape. An outer longitudinal size of the magnetic conducting assembly is greater than or equal to an outer longitudinal size of the radially magnetized permanent magnet 320. The magnetic conducting assembly may be disposed on an outer side of the radially magnetized permanent magnet 320, and is configured to absorb a magnetic field around the radially magnetized permanent magnet 320. In an embodiment, a top-view cross-sectional shape of the magnetic conducting assembly is a circular shape or a polygonal shape. The magnetic conducting assembly may be disposed on an upper side or a lower side of the magnetic alignment apparatus 300. That is, the magnetic conducting assembly may be disposed on an upper side or a lower side of the axially magnetized permanent magnet 310 and the radially magnetized permanent magnet 320.

In an embodiment of this application, the magnetic alignment apparatus of the wireless charging module includes a first permanent magnet and a second permanent magnet, and the first permanent magnet and the second permanent magnet are disposed on one surface. A magnetization manner for the first permanent magnet is different from a magnetization manner for the second permanent magnet. The magnetization manner for the first permanent magnet is axial magnetization, and the magnetization manner for the second permanent magnet is radial magnetization. Magnetic fields of the first permanent magnet and the second permanent magnet are mutually enhanced on one side of the magnetic alignment apparatus, thereby enhancing magnetic field strength on the one side of the magnetic alignment apparatus. The magnetic fields of the first permanent magnet and the second permanent magnet are mutually weakened on the other side of the magnetic alignment apparatus, thereby reducing magnetic field strength on the other side of the magnetic alignment apparatus. The magnetic field strength on the one side of the magnetic alignment apparatus is stronger than the magnetic field strength on the other side of the magnetic alignment apparatus. The magnetic field strength on the one side of the magnetic alignment apparatus is different from the magnetic field strength on the other side of the magnetic alignment apparatus.

In an embodiment, a magnetic field direction in the first permanent magnet is perpendicular to the surface, and a magnetic field direction in the second permanent magnet is parallel to the surface. The magnetic field direction in the first permanent magnet is perpendicular to the magnetic field direction in the second permanent magnet.

In an embodiment, a magnetic field direction in the first permanent magnet is parallel to the surface, and a magnetic field direction in the second permanent magnet is perpendicular to the surface. The magnetic field direction in the first permanent magnet is perpendicular to the magnetic field direction in the second permanent magnet.

In an embodiment, a top-view cross-sectional shape of the first permanent magnet is one of a circular shape or a polygonal shape, and a top-view cross-sectional shape of the second permanent magnet is a ring shape. The ring shape includes a circular ring shape or a polygonal ring shape.

In an embodiment, the first permanent magnet is fastened to the second permanent magnet.

In an embodiment, the first permanent magnet and the second permanent magnet are separately fastened to the surface.

In an embodiment, the magnetic alignment apparatus includes a magnetic conducting assembly. The magnetic conducting assembly is disposed on an outer side of the second permanent magnet or on an upper side or a lower side of the magnetic alignment apparatus.

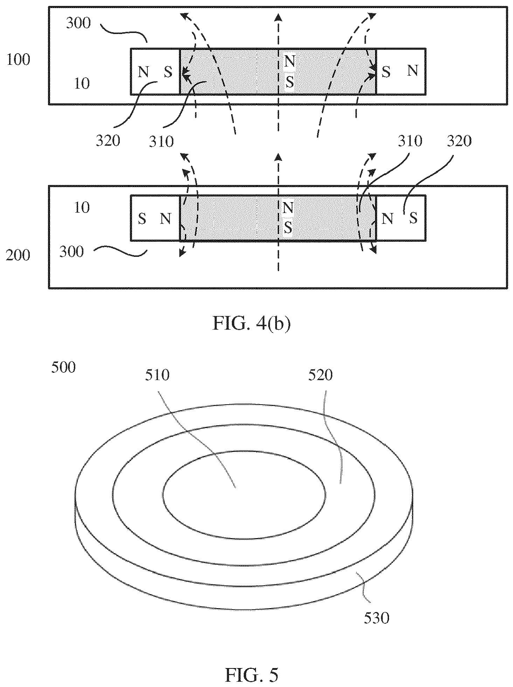

The magnetic alignment apparatus 300 provided in this embodiment of this application may be used in the wireless charging module 20 shown in FIG. 2. FIG. 4(b) is a schematic diagram of a structure of another electronic device and a charger thereof according to an embodiment of this application. A difference between FIG. 4(b) and FIG. 2 lies in that the magnetic alignment apparatus 30 of the wireless charging module 10 shown in FIG. 2 is replaced with the magnetic alignment apparatus 300 shown in FIG. 3. For ease of description, the charging coil 20 in the wireless charging module 10 shown in FIG. 2 is omitted in FIG. 4(b).

As shown in FIG. 4(b), a magnetic alignment apparatus 300 in the electronic device 100 and a magnetic alignment apparatus 300 in the charger 200 may be magnetically attracted to each other, to limit a contact location between the electronic device 100 and the charger 200, thereby facilitating matching between a charging coil 20 of the electronic device 100 and a charging coil 20 of the charger 200, and improving convenience of wireless charging.

As shown in FIG. 4(b), the magnetic alignment apparatus 300 is disposed on a lower side in the electronic device 100. An axially magnetized permanent magnet 310 and a radially magnetized permanent magnet 320 of the magnetic alignment apparatus 300 are disposed adjacently on one surface. In an embodiment, the axially magnetized permanent magnet 310 and the radially magnetized permanent magnet 320 of the magnetic alignment apparatus 300 may be disposed adjacently on an inner surface of a housing on a lower side of the electronic device 100, or on a substrate in the electronic device 100. That is, the one surface may be the inner surface of the housing on the lower side of the electronic device 100 or the substrate in the electronic device 100. In the electronic device 100, magnetic field strength on an upper side of the magnetic alignment apparatus 300 is reduced, and magnetic field strength on a lower side of the magnetic alignment apparatus 300 is enhanced. That is, the magnetic field strength on the upper side of the magnetic alignment apparatus 300 in the electronic device 100 is weaker than the magnetic field strength on the lower side of the magnetic alignment apparatus 300 in the electronic device 100.

For example, an N pole of the axially magnetized permanent magnet 310 faces upward, and an S pole faces downward. An S pole of the radially magnetized permanent magnet 320 faces an inner side of a circular ring, and an N pole faces an outer side of the circular ring. Correspondingly, magnetic fields of the axially magnetized permanent magnet 310 and the radially magnetized permanent magnet 320 are mutually enhanced on the lower side of the magnetic alignment apparatus 300, the magnetic field strength on the lower side of the magnetic alignment apparatus 300 is enhanced, and a magnetic attraction force between the lower side of the electronic device 100 and an upper side of the charger 200 is enhanced. Therefore, the contact location between the electronic device 100 and the charger 200 can be better limited, thereby facilitating matching between the charging coil of the electronic device 100 and the charging coil of the charger 200, and improving convenience of wireless charging. The magnetic fields of the axially magnetized permanent magnet 310 and the radially magnetized permanent magnet 320 are mutually weakened on the upper side of the magnetic alignment apparatus 300, and the magnetic field strength on the upper side of the magnetic alignment apparatus 300 is reduced. Therefore, impact of the magnetic alignment apparatus 300 on another magnetic field-sensitive device on an upper side in the electronic device 100 can be reduced, and soft magnetic materials can also be omitted or reduced, thereby facilitating heat dissipation and miniaturization of the electronic device 100.

As shown in FIG. 4(b), the magnetic alignment apparatus 300 is disposed on an upper side in the charger 200. An axially magnetized permanent magnet 310 and a radially magnetized permanent magnet 320 of the magnetic alignment apparatus 300 are disposed adjacently on one surface. In an embodiment, the axially magnetized permanent magnet 310 and the radially magnetized permanent magnet 320 of the magnetic alignment apparatus 300 may be disposed adjacently on an inner surface of a housing on an upper side of the charger 200, or on a substrate in the charger 200. That is, the one surface may be the inner surface of the housing on the upper side of the charger 200 or the substrate in the charger 200. In the charger 200, magnetic field strength on an upper side of the magnetic alignment apparatus 300 is enhanced, and magnetic field strength on a lower side of the magnetic alignment apparatus 300 is reduced. That is, the magnetic field strength on the upper side of the magnetic alignment apparatus 300 in the charger 200 is stronger than the magnetic field strength on the lower side of the magnetic alignment apparatus 300 in the charger 200.

For example, an N pole of the axially magnetized permanent magnet 310 faces upward, and an S pole faces downward. An N pole of the radially magnetized permanent magnet 320 faces an inner side of a circular ring, and an S pole faces an outer side of the circular ring. Correspondingly, magnetic fields of the axially magnetized permanent magnet 310 and the radially magnetized permanent magnet 320 are mutually enhanced on the upper side of the magnetic alignment apparatus 300, the magnetic field strength on the upper side of the magnetic alignment apparatus 300 is enhanced, and a magnetic attraction force between the upper side of the charger 200 and the lower side of the electronic device 100 is enhanced. Therefore, the contact location between the electronic device 100 and the charger 200 can be better limited, thereby facilitating matching between the charging coil of the electronic device 100 and the charging coil of the charger 200, and improving convenience of wireless charging. The magnetic fields of the axially magnetized permanent magnet 310 and the radially magnetized permanent magnet 320 are mutually weakened on the lower side of the magnetic alignment apparatus 300, and the magnetic field strength on the lower side of the magnetic alignment apparatus 300 is reduced. This not only can reduce impact of the magnetic alignment apparatus 300 in the charger 200 on another magnetically sensitive device, but also can omit or reduce soft magnetic materials, thereby facilitating heat dissipation and miniaturization of the charger 200.

In this embodiment, a top-view cross-sectional shape of the axially magnetized permanent magnet 310 in the magnetic alignment apparatus 300 is a circular shape or a polygonal shape, and the charging coil 20 of the wireless charging module 10 may be disposed on an outer side of the radially magnetized permanent magnet 320 of the magnetic alignment apparatus 300.

In this embodiment of this application, the charging coil of the wireless charging module may be disposed on an inner side of the first permanent magnet of the magnetic alignment apparatus, or the charging coil of the wireless charging module may be disposed on an outer side of the second permanent magnet of the magnetic alignment apparatus.

FIG. 5 is a schematic diagram of a structure of another magnetic alignment apparatus according to an embodiment of this application. As shown in FIG. 5, the magnetic alignment apparatus 500 includes a first axially magnetized permanent magnet 510, a radially magnetized permanent magnet 520, and a second axially magnetized permanent magnet 530. The first axially magnetized permanent magnet 510, the radially magnetized permanent magnet 520, and the second axially magnetized permanent magnet 530 are disposed adjacently on one surface in sequence. In this embodiment, the first axially magnetized permanent magnet 510 is in a cylindrical structure, and a top-view cross-sectional shape of the first axially magnetized permanent magnet 510 is a circular shape. The radially magnetized permanent magnet 520 is in a cylindrical structure, and a top-view cross-sectional shape of the radially magnetized permanent magnet 520 is a circular ring shape. An inner longitudinal size of the radially magnetized permanent magnet 520 is greater than or equal to a longitudinal size of the first axially magnetized permanent magnet 510. The first axially magnetized permanent magnet 510 may be disposed on an inner side of the radially magnetized permanent magnet 520. The second axially magnetized permanent magnet 530 is in a ring-shaped cylindrical structure, and a top-view cross-sectional shape of the second axially magnetized permanent magnet 530 is a circular ring shape. An inner longitudinal size of the second axially magnetized permanent magnet 530 is greater than or equal to an outer longitudinal size of the radially magnetized permanent magnet 520. The second axially magnetized permanent magnet 530 may be disposed on an outer side of the radially magnetized permanent magnet 520. In an embodiment, the first axially magnetized permanent magnet 510, the radially magnetized permanent magnet 520, and the second axially magnetized permanent magnet 530 may be fastened to form an integrated structure. In an embodiment, the first axially magnetized permanent magnet 510, the radially magnetized permanent magnet 520, and the second axially magnetized permanent magnet 530 may be separately fastened to the surface.

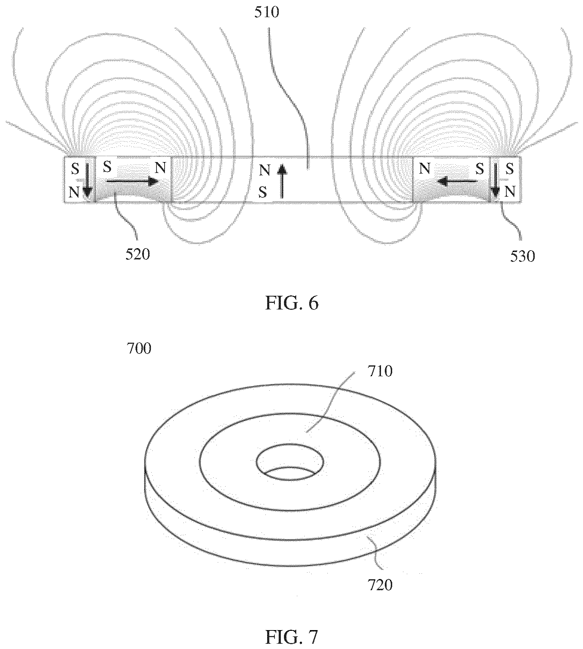

FIG. 6 is a schematic diagram of magnetic fields of the permanent magnets in the magnetic alignment apparatus shown in FIG. 5. As shown in FIG. 6, the first axially magnetized permanent magnet 510, the radially magnetized permanent magnet 520, and the second axially magnetized permanent magnet 530 are disposed adjacently on one surface in sequence. An N pole of the first axially magnetized permanent magnet 510 faces upward, and an S pole faces downward. An N pole of the radially magnetized permanent magnet 520 faces an inner side of a circular ring, and an S pole faces an outer side of the circular ring. An S pole of the second axially magnetized permanent magnet 530 faces upward, and an N pole faces downward. Correspondingly, magnetic fields of the first axially magnetized permanent magnet 510 and the radially magnetized permanent magnet 520 are mutually enhanced on an upper side of the magnetic alignment apparatus 500, thereby enhancing magnetic field strength on the upper side of the magnetic alignment apparatus 500. The magnetic fields of the first axially magnetized permanent magnet 510 and the radially magnetized permanent magnet 520 are mutually weakened on a lower side of the magnetic alignment apparatus 500, thereby reducing magnetic field strength on the lower side of the magnetic alignment apparatus 500. Magnetic fields of the second axially magnetized permanent magnet 530, the first axially magnetized permanent magnet 510, and the radially magnetized permanent magnet 520 may form a loop on the upper side of the magnetic alignment apparatus 500, thereby constraining a magnetic field of the magnetic alignment apparatus 500, and reducing magnetic field strength around the magnetic alignment apparatus 500. In addition, the second axially magnetized permanent magnet 530 may further absorb a magnetic field of the radially magnetized permanent magnet 520, to reduce the magnetic field strength around the magnetic alignment apparatus 500.

In an embodiment, a magnetic field direction in the first axially magnetized permanent magnet 510 is perpendicular to the surface, a magnetic field direction in the radially magnetized permanent magnet 520 is parallel to the surface, and a magnetic field direction in the second axially magnetized permanent magnet 530 is perpendicular to the surface. The magnetic field direction in the radially magnetized permanent magnet 520 is perpendicular to the magnetic field direction in the first axially magnetized permanent magnet 510 or the magnetic field direction in the second axially magnetized permanent magnet 530. That is, an included angle between the magnetic field direction in the first axially magnetized permanent magnet 510 and the surface is 90 degrees, an included angle between the magnetic field direction in the radially magnetized permanent magnet 520 and the surface is 0 degrees, and an included angle between the magnetic field direction in the second axially magnetized permanent magnet 530 and the surface is 90 degrees. An included angle between the magnetic field direction in the radially magnetized permanent magnet 520 and the magnetic field direction in the first axially magnetized permanent magnet 510 or the magnetic field direction in the second axially magnetized permanent magnet 530 is 90 degrees. In another embodiment, an included angle between the magnetic field direction in the first axially magnetized permanent magnet 510 and the surface may be less than 90 degrees, an included angle between the magnetic field direction in the radially magnetized permanent magnet 520 and the surface may be greater than 0 degrees, and an included angle between the magnetic field direction in the second axially magnetized permanent magnet 530 and the surface may be less than 90 degrees. An included angle between the magnetic field direction in the radially magnetized permanent magnet 520 and the magnetic field direction in the first axially magnetized permanent magnet 510 or the magnetic field direction in the second axially magnetized permanent magnet 530 may be less than 90 degrees.

In the magnetic alignment apparatus 500 implemented in this application, the magnetic field direction of the first axially magnetized permanent magnet 510 is opposite to the magnetic field direction of the second axially magnetized permanent magnet 530. In an embodiment, an included angle between the magnetic field direction of the first axially magnetized permanent magnet 510 and the magnetic field direction of the second axially magnetized permanent magnet 530 is 180 degrees. In another embodiment, an included angle between the magnetic field direction of the first axially magnetized permanent magnet 510 and the magnetic field direction of the second axially magnetized permanent magnet 530 may be less than 180 degrees.

Internal magnetic field directions of the first axially magnetized permanent magnet 510, the radially magnetized permanent magnet 520, and the second axially magnetized permanent magnet 530 in the magnetic alignment apparatus 500 alternatively include another combination, to enhance the magnetic field strength on the upper side of the magnetic alignment apparatus 500 and reduce the magnetic field strength on the lower side of the magnetic alignment apparatus 500. For example, an S pole of the first axially magnetized permanent magnet 510 faces upward, and an N pole faces downward. An S pole of the radially magnetized permanent magnet 520 faces an inner side of a circular ring, and an N pole faces an outer side of the circular ring. An N pole of the second axially magnetized permanent magnet 530 faces upward, and an S pole faces downward. Correspondingly, magnetic fields of the first axially magnetized permanent magnet 510 and the radially magnetized permanent magnet 520 are mutually enhanced on an upper side of the magnetic alignment apparatus 500, thereby enhancing magnetic field strength on the upper side of the magnetic alignment apparatus 500. The magnetic fields of the first axially magnetized permanent magnet 510 and the radially magnetized permanent magnet 520 are mutually weakened on a lower side of the magnetic alignment apparatus 500, thereby reducing magnetic field strength on the lower side of the magnetic alignment apparatus 500. Magnetic fields of the second axially magnetized permanent magnet 530, the first axially magnetized permanent magnet 510, and the radially magnetized permanent magnet 520 may form a loop on the upper side of the magnetic alignment apparatus 500, thereby constraining a magnetic field of the magnetic alignment apparatus 500, and reducing magnetic field strength around the magnetic alignment apparatus 500. In addition, the second axially magnetized permanent magnet 530 may further absorb a magnetic field of the radially magnetized permanent magnet 520, to reduce the magnetic field strength around the magnetic alignment apparatus 500.

The magnetic alignment apparatus 500 provided in this embodiment of this application is similar to the magnetic alignment apparatus 300, and the upper side and the lower side of the magnetic alignment apparatus 500 are symmetrical. That is, magnetic field strength on one side of the magnetic alignment apparatus 500 is enhanced, and magnetic field strength on the other side of the magnetic alignment apparatus 500 is reduced. The magnetic field strength on the one side of the magnetic alignment apparatus 500 is different from the magnetic field strength on the other side of the magnetic alignment apparatus 500. The magnetic field strength on the one side of the magnetic alignment apparatus 500 is stronger than the magnetic field strength on the other side of the magnetic alignment apparatus 500.

The magnetic alignment apparatus 500 provided in this embodiment of this application is similar to the magnetic alignment apparatus 300, and the magnetic alignment apparatus 500 may also be used in the wireless charging module 10 shown in FIG. 2. In this embodiment, a top-view cross-sectional shape of the first axially magnetized permanent magnet 510 in the magnetic alignment apparatus 500 is a circular shape or a polygonal shape, and the charging coil in the wireless charging module 10 may be disposed on an outer side of the second axially magnetized permanent magnet 530 of the magnetic alignment apparatus 500.

The magnetic alignment apparatus provided in this embodiment of this application includes a first permanent magnet, a second permanent magnet, and a third permanent magnet. The first permanent magnet, the second permanent magnet, and the third permanent magnet are disposed adjacently on one surface in sequence. A magnetization manner for the first permanent magnet is different from a magnetization manner for the second permanent magnet. A magnetization manner for the third permanent magnet is the same as the magnetization manner for the first permanent magnet. A magnetic field direction in the third permanent magnet is opposite to a magnetic field direction in the first permanent magnet.

In an embodiment, the magnetization manners for the first permanent magnet, the second permanent magnet, and the third permanent magnet include axial magnetization or radial magnetization.

In an embodiment, a magnetic field direction in the first permanent magnet is perpendicular to the surface, a magnetic field direction in the second permanent magnet is parallel to the surface, and a magnetic field direction in the third permanent magnet is perpendicular to the surface.

In an embodiment, the magnetization manner for the first permanent magnet is axial magnetization, the magnetization manner for the second permanent magnet is radial magnetization, and the magnetization manner for the third permanent magnet is axial magnetization.

In an embodiment, the first permanent magnet, the second permanent magnet, and the third permanent magnet are fastened to each other.

In an embodiment, the first permanent magnet, the second permanent magnet, and the third permanent magnet are separately fastened to the surface.

In an embodiment, the charging coil of the wireless charging module is disposed on an outer side of the third permanent magnet of the magnetic alignment apparatus.

FIG. 7 is a schematic diagram of a structure of another magnetic alignment apparatus according to an embodiment of this application. As shown in FIG. 7, the magnetic alignment apparatus 700 includes an axially magnetized permanent magnet 710 and a radially magnetized permanent magnet 720. The axially magnetized permanent magnet 710 is in a ring-shaped cylindrical structure, and a top-view cross-sectional shape of the axially magnetized permanent magnet 710 is a circular ring shape. The radially magnetized permanent magnet 720 is in a ring-shaped cylindrical structure, and a top-view cross-sectional shape of the radially magnetized permanent magnet 720 is a circular ring shape. In some embodiments, the axially magnetized permanent magnet 710 or the radially magnetized permanent magnet 720 may be in a ring-shaped polygonal cylindrical structure. Correspondingly, a top-view cross-sectional shape of the axially magnetized permanent magnet 710 or the radially magnetized permanent magnet 720 may be a polygonal ring shape. That is, the top-view cross-sectional shape of the axially magnetized permanent magnet 710 or the radially magnetized permanent magnet 720 may be a ring shape. The ring shape includes a circular ring shape, a polygonal ring shape, or another irregular ring shape.

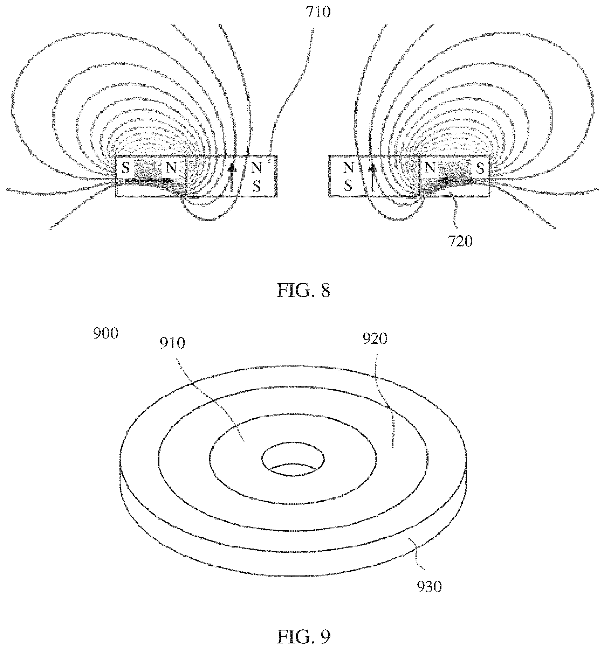

As shown in FIG. 8, the axially magnetized permanent magnet 710 and the radially magnetized permanent magnet 720 are disposed on one surface. An N pole of the axially magnetized permanent magnet 310 faces upward, and an S pole faces downward. An N pole of the radially magnetized permanent magnet 320 faces an inner side of a circular ring, and an S pole faces an outer side of the circular ring. Correspondingly, magnetic field strength on an upper side of the magnetic alignment apparatus 700 is enhanced, and magnetic field strength on a lower side of the magnetic alignment apparatus 700 is reduced.

Internal magnetic field directions of the axially magnetized permanent magnet 710 and the radially magnetized permanent magnet 720 in the magnetic alignment apparatus 700 alternatively include another combination, to enhance the magnetic field strength on the upper side of the magnetic alignment apparatus 700 and reduce the magnetic field strength on the lower side of the magnetic alignment apparatus 700. For example, an S pole of the axially magnetized permanent magnet 710 faces upward, and an N pole faces downward. An S pole of the radially magnetized permanent magnet 720 faces an inner side of a circular ring, and an N pole faces an outer side of the circular ring. Correspondingly, magnetic field strength on an upper side of the magnetic alignment apparatus 700 is enhanced, and magnetic field strength on a lower side is reduced.

It can be understood that the axially magnetized permanent magnet 710 in the magnetic alignment apparatus 700 is in a ring structure, so that a weight and costs of the magnetic alignment apparatus 700 can be reduced, thereby reducing weights and costs of the electronic device 100 and the charger 200.

The magnetic alignment apparatus 700 provided in this embodiment of this application is similar to the magnetic alignment apparatus 300, and the upper side and the lower side of the magnetic alignment apparatus 700 are symmetrical. That is, magnetic field strength on one side of the magnetic alignment apparatus 700 is enhanced, and magnetic field strength on the other side of the magnetic alignment apparatus 700 is reduced. The magnetic field strength on the one side of the magnetic alignment apparatus 700 is stronger than the magnetic field strength on the other side of the magnetic alignment apparatus 700.

The magnetic alignment apparatus 700 provided in this embodiment of this application is similar to the magnetic alignment apparatus 300, and the magnetic alignment apparatus 700 may also be used in the wireless charging module 10 shown in FIG. 2. In an embodiment, an inner longitudinal size of the axially magnetized permanent magnet 710 in the magnetic alignment apparatus 700 is greater than or equal to an outer longitudinal size of the charging coil 20 of the wireless charging module 10, and the charging coil 20 of the wireless charging module 10 may be disposed on an inner side of the axially magnetized permanent magnet 710. In an embodiment, an outer longitudinal size of the radially magnetized permanent magnet 720 in the magnetic alignment apparatus 700 is less than an inner longitudinal size of the charging coil 20 of the wireless charging module 10, and the charging coil 20 of the wireless charging module 10 may be disposed on an outer side of the radially magnetized permanent magnet 720 of the magnetic alignment apparatus 700.

A first permanent magnet and a second permanent magnet of the magnetic alignment apparatus provided in this embodiment of this application are in ring shapes, so that a weight and costs of the magnetic alignment apparatus can be reduced, thereby helping reduce weights and costs of the electronic device and the charger.

An outer longitudinal size of the charging coil of the wireless charging module provided in this embodiment of this application is less than an inner longitudinal size of the first permanent magnet of the magnetic alignment apparatus, and the charging coil of the wireless charging module may be disposed on an inner side of the first permanent magnet of the magnetic alignment apparatus. Alternatively, an inner longitudinal size of the charging coil of the wireless charging module is greater than an outer longitudinal size of the second permanent magnet of the magnetic alignment apparatus, and the charging coil of the wireless charging module may be disposed on an outer side of the second permanent magnet of the magnetic alignment apparatus.

FIG. 9 is a schematic diagram of a structure of another magnetic alignment apparatus according to an embodiment of this application. As shown in FIG. 9, the magnetic alignment apparatus 900 includes a first axially magnetized permanent magnet 910, a radially magnetized permanent magnet 920, and a second axially magnetized permanent magnet 930. The first axially magnetized permanent magnet 910, the radially magnetized permanent magnet 920, and the second axially magnetized permanent magnet 930 are in ring-shaped cylindrical structures. Top-view cross-sectional shapes of the first axially magnetized permanent magnet 910, the radially magnetized permanent magnet 920, and the second axially magnetized permanent magnet 930 are circular ring shapes. An inner longitudinal size of the radially magnetized permanent magnet 920 is greater than or equal to an outer longitudinal size of the first axially magnetized permanent magnet 910. The first axially magnetized permanent magnet 910 is disposed on an inner side of the radially magnetized permanent magnet 920. An inner longitudinal size of the second axially magnetized permanent magnet 930 is greater than or equal to an outer longitudinal size of the radially magnetized permanent magnet 920. The radially magnetized permanent magnet 920 may be disposed on an inner side of the second axially magnetized permanent magnet 930. In an embodiment, the first axially magnetized permanent magnet 910, the radially magnetized permanent magnet 920, and the second axially magnetized permanent magnet 930 may be fastened to form an integrated structure.

In another embodiment, the first axially magnetized permanent magnet 910, the radially magnetized permanent magnet 920, or the second axially magnetized permanent magnet 930 is in a ring-shaped polygonal cylindrical structure. Correspondingly, a top-view cross-sectional shape of the first axially magnetized permanent magnet 910, the radially magnetized permanent magnet 920, or the second axially magnetized permanent magnet 930 may be a polygonal ring shape. That is, the top-view cross-sectional shape of the first axially magnetized permanent magnet 910, the radially magnetized permanent magnet 920, or the second axially magnetized permanent magnet 930 may be a ring shape. The ring shape includes a circular ring shape, a polygonal ring shape, or another irregular ring shape.

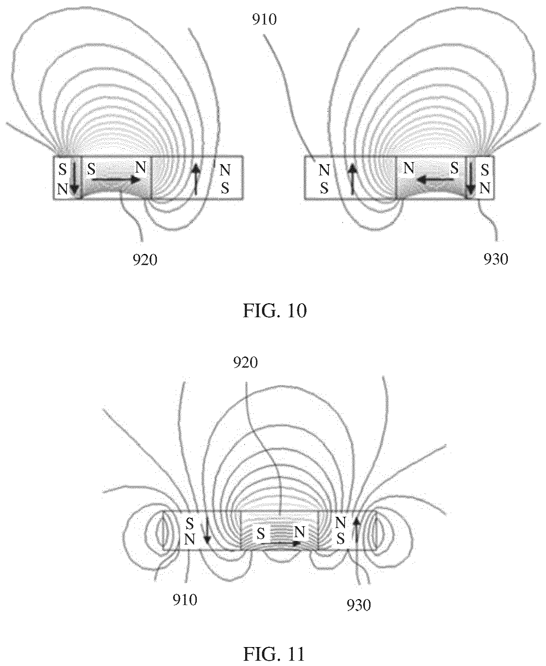

FIG. 10 is a schematic diagram of a magnetic field of a permanent magnet of another magnetic alignment apparatus according to an embodiment of this application. As shown in FIG. 10, an N pole of the first axially magnetized permanent magnet 910 faces upward, and an S pole faces downward. An N pole of the radially magnetized permanent magnet 920 faces an inner side of a circular ring, and an S pole faces an outer side of the circular ring. An S pole of the second axially magnetized permanent magnet 930 faces upward, and an N pole faces downward. Correspondingly, magnetic field strength on a lower side of the magnetic alignment apparatus 900 is reduced, magnetic field strength on an upper side of the magnetic alignment apparatus 900 is enhanced, and magnetic field strength around the magnetic alignment apparatus 900 is reduced.

Internal magnetic field directions of the first axially magnetized permanent magnet 910, the radially magnetized permanent magnet 920, and the second axially magnetized permanent magnet 930 in the magnetic alignment apparatus 900 alternatively include another combination, to enhance the magnetic field strength on the upper side of the magnetic alignment apparatus 900 and reduce the magnetic field strength on the lower side of the magnetic alignment apparatus 900. FIG. 11 is a schematic diagram of a magnetic field of a permanent magnet of another magnetic alignment apparatus according to an embodiment of this application. As shown in FIG. 11, an S pole of the first axially magnetized permanent magnet 910 in the magnetic alignment apparatus 900 faces upward, and an N pole faces downward. An S pole of the radially magnetized permanent magnet 920 faces an inner side of a circular ring, and an N pole faces an outer side of the circular ring. An N pole of the second axially magnetized permanent magnet 930 faces upward, and an S pole faces downward. Correspondingly, magnetic field strength on an upper side of the magnetic alignment apparatus 900 is enhanced, magnetic field strength on a lower side of the magnetic alignment apparatus 900 is reduced, and a magnetic field strength around the magnetic alignment apparatus 900 is reduced.

The magnetic alignment apparatus 900 provided in this embodiment of this application is similar to the magnetic alignment apparatus 500, and the upper side and the lower side of the magnetic alignment apparatus 900 are symmetrical. That is, magnetic field strength on one side of the magnetic alignment apparatus 900 is enhanced, and magnetic field strength on the other side of the magnetic alignment apparatus 900 is reduced. The magnetic field strength on the one side of the magnetic alignment apparatus 900 is stronger than the magnetic field strength on the other side of the magnetic alignment apparatus 900.

The magnetic alignment apparatus 900 provided in this embodiment of this application is similar to the magnetic alignment apparatus 500, and the magnetic alignment apparatus 900 may also be used in the wireless charging module 10 shown in FIG. 2. In an embodiment, an outer longitudinal size of the third axially magnetized permanent magnet 930 in the magnetic alignment apparatus 900 is less than an inner longitudinal size of the charging coil 20 of the wireless charging module 10, and the charging coil 20 of the wireless charging module 10 may be disposed on an outer side of the third axially magnetized permanent magnet 930 of the magnetic alignment apparatus 900.

The first axially magnetized permanent magnet 910 in the magnetic alignment apparatus 900 provided in this embodiment of this application is in a ring structure, so that a weight and costs of the magnetic alignment apparatus 900 can be reduced, thereby reducing weights and costs of the electronic device 100 and the charger 200.

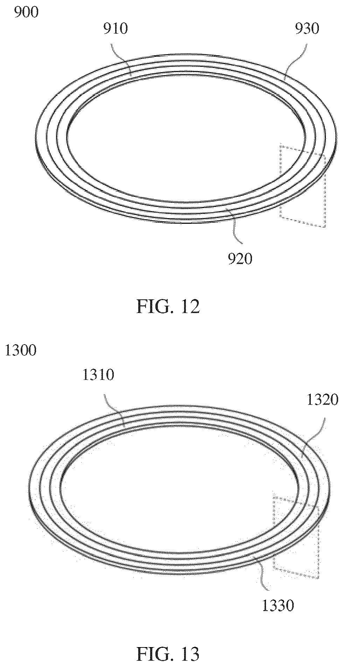

FIG. 12 is a schematic diagram of a structure of another magnetic alignment apparatus according to an embodiment of this application. As shown in FIG. 12, an inner longitudinal size of the first axially magnetized permanent magnet 910 in the magnetic alignment apparatus 900 is large to accommodate the charging coil 20 of the wireless charging module 10. The inner longitudinal size of the first axially magnetized permanent magnet 910 in the magnetic alignment apparatus 900 is greater than or equal to an outer longitudinal size of the charging coil 20 of the wireless charging module 10, and the charging coil 20 of the wireless charging module 10 may be disposed on an inner side of the first axially magnetized permanent magnet 910 of the magnetic alignment apparatus 900.

In this embodiment of this application, a first permanent magnet, a second permanent magnet, and a third permanent magnet of the magnetic alignment apparatus are in ring shapes, so that a weight and costs of the magnetic alignment apparatus can be reduced, thereby helping reduce weights and costs of the electronic device and the charger.

An outer longitudinal size of the charging coil of the wireless charging module provided in this embodiment of this application is less than an inner longitudinal size of the first permanent magnet of the magnetic alignment apparatus, and the charging coil of the wireless charging module may be disposed on an inner side of the first permanent magnet of the magnetic alignment apparatus. Alternatively, an inner longitudinal size of the charging coil of the wireless charging module is greater than an outer longitudinal size of the third permanent magnet of the magnetic alignment apparatus, and the charging coil of the wireless charging module may be disposed on an outer side of the third permanent magnet of the magnetic alignment apparatus.

FIG. 13 is a schematic diagram of a structure of another magnetic alignment apparatus according to an embodiment of this application. As shown in FIG. 13, the magnetic alignment apparatus 1300 includes a first radially magnetized permanent magnet 1310 and an axially magnetized permanent magnet 1320. The first radially magnetized permanent magnet 1310 and the axially magnetized permanent magnet 1320 are in ring-shaped cylindrical structures. Top-view cross-sectional shapes of the first radially magnetized permanent magnet 1310 and the axially magnetized permanent magnet 1320 are circular ring shapes. An inner longitudinal size of the axially magnetized permanent magnet 1320 is greater than or equal to an outer longitudinal size of the first radially magnetized permanent magnet 1310. The first radially magnetized permanent magnet 1310 is disposed on an inner side of the axially magnetized permanent magnet 1320.

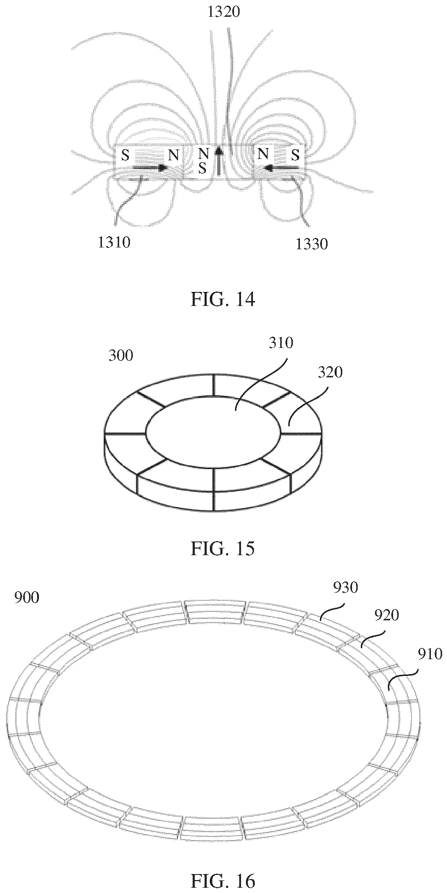

FIG. 14 is a schematic diagram of a magnetic field of a permanent magnet of another magnetic alignment apparatus according to an embodiment of this application. As shown in FIG. 14, the first radially magnetized permanent magnet 1310 and the axially magnetized permanent magnet 1320 in the magnetic alignment apparatus 1300 are disposed on one surface. An S pole of the first radially magnetized permanent magnet 1310 faces an inner side of a circular ring, and an N pole faces an outer side of the circular ring. An N pole of the axially magnetized permanent magnet 1320 faces upward, and an S pole faces downward. Correspondingly, magnetic fields of the first radially magnetized permanent magnet 1310 and the axially magnetized permanent magnet 1320 are mutually enhanced on an upper side of the magnetic alignment apparatus 1300, thereby enhancing magnetic field strength on the upper side of the magnetic alignment apparatus 1300. The magnetic fields of the first radially magnetized permanent magnet 1310 and the axially magnetized permanent magnet 1320 are mutually weakened on a lower side of the magnetic alignment apparatus 1300, thereby reducing magnetic field strength on the lower side of the magnetic alignment apparatus 1300.

Internal magnetic field directions of the first radially magnetized permanent magnet 1310 and the axially magnetized permanent magnet 1320 in the magnetic alignment apparatus 1300 alternatively include another combination, to enhance the magnetic field strength on the upper side of the magnetic alignment apparatus 700 and reduce the magnetic field strength on the lower side of the magnetic alignment apparatus 700. For example, an S pole of the first radially magnetized permanent magnet 1310 faces an outer side of a circular ring, and an N pole faces an inner side of the circular ring. An N pole of the axially magnetized permanent magnet 1320 faces downward, and an S pole faces upward. Correspondingly, magnetic field strength on an upper side of the magnetic alignment apparatus 1300 is enhanced, and magnetic field strength on a lower side of the magnetic alignment apparatus 1300 is reduced.

In an embodiment, a magnetic field direction in the first radially magnetized permanent magnet 1310 is parallel to the surface, and a magnetic field direction in the axially magnetized permanent magnet 1320 is perpendicular to the surface. The magnetic field direction in the axially magnetized permanent magnet 1320 is perpendicular to the magnetic field direction in the first radially magnetized permanent magnet 1310. That is, an included angle between the magnetic field direction in the first radially magnetized permanent magnet 1310 and the surface is 0 degrees, and an included angle between the magnetic field direction in the axially magnetized permanent magnet 1320 and the surface is 90 degrees. An included angle between the magnetic field direction in the axially magnetized permanent magnet 1320 and the magnetic field direction in the first radially magnetized permanent magnet 1310 is 90 degrees. In another embodiment, an included angle between the magnetic field direction in the first radially magnetized permanent magnet 1310 and the surface may be greater than 0 degrees, and an included angle between the magnetic field direction in the axially magnetized permanent magnet 1320 and the surface may be less than 90 degrees. An included angle between the magnetic field direction in the axially magnetized permanent magnet 1320 and the magnetic field direction in the first radially magnetized permanent magnet 1310 may be less than 90 degrees.

In this embodiment of this application, the magnetic alignment apparatus 1300 may further include a second radially magnetized permanent magnet 1330. As shown in FIG. 13, the magnetic alignment apparatus 1300 includes the first radially magnetized permanent magnet 1310, the axially magnetized permanent magnet 1320, and the second radially magnetized permanent magnet 1330. The first radially magnetized permanent magnet 1310, the axially magnetized permanent magnet 1320, and the second radially magnetized permanent magnet 1330 are in ring-shaped cylindrical structures. Top-view cross-sectional shapes of the first radially magnetized permanent magnet 1310, the axially magnetized permanent magnet 1320, and the second radially magnetized permanent magnet 1330 are circular ring shapes. An inner longitudinal size of the axially magnetized permanent magnet 1320 is greater than or equal to an outer longitudinal size of the first radially magnetized permanent magnet 1310. The first radially magnetized permanent magnet 1310 is disposed in the axially magnetized permanent magnet 1320. An inner longitudinal size of the second radially magnetized permanent magnet 1330 is greater than or equal to an outer longitudinal size of the axially magnetized permanent magnet 1320. The second radially magnetized permanent magnet 1330 may be disposed on an outer side of the axially magnetized permanent magnet 1320.

As shown in FIG. 14, the first radially magnetized permanent magnet 1310, the axially magnetized permanent magnet 1320, and the second radially magnetized permanent magnet 1330 in the magnetic alignment apparatus 1300 are disposed on one surface. An S pole of the first radially magnetized permanent magnet 1310 faces an inner side of a circular ring, and an N pole faces an outer side of the circular ring. An N pole of the axially magnetized permanent magnet 1320 faces upward, and an S pole faces downward. An N pole of the second radially magnetized permanent magnet 1330 faces an inner side of a circular ring, and an S pole faces an outer side of the circular ring. Correspondingly, magnetic field strength on an upper side of the magnetic alignment apparatus 1300 is enhanced, magnetic field strength on a lower side of the magnetic alignment apparatus 1300 is reduced, and magnetic field strength around the magnetic alignment apparatus 1300 is reduced.

Internal magnetic field directions of the first radially magnetized permanent magnet 1310, the axially magnetized permanent magnet 1320, and the second radially magnetized permanent magnet 1330 in the magnetic alignment apparatus 1300 alternatively include another combination, to enhance the magnetic field strength on the upper side of the magnetic alignment apparatus 700 and reduce the magnetic field strength on the lower side of the magnetic alignment apparatus 700. For example, an S pole of the first radially magnetized permanent magnet 1310 faces an outer side of a circular ring, and an N pole faces an inner side of the circular ring. An N pole of the axially magnetized permanent magnet 1320 faces downward, and an S pole faces upward. An N pole of the second radially magnetized permanent magnet 1330 faces an outer side of a circular ring, and an S pole faces an inner side of the circular ring. Correspondingly, magnetic field strength on an upper side of the magnetic alignment apparatus 1300 is enhanced, magnetic field strength on a lower side of the magnetic alignment apparatus 1300 is reduced, and magnetic field strength around the magnetic alignment apparatus 1300 is reduced.

In an embodiment, in the magnetic alignment apparatus 1300, a magnetic field direction in the first radially magnetized permanent magnet 1310 is parallel to the surface, a magnetic field direction in the axially magnetized permanent magnet 1320 is perpendicular to the surface, and a magnetic field direction in the second radially magnetized permanent magnet 1330 is parallel to the surface. The magnetic field direction in the axially magnetized permanent magnet 1320 is perpendicular to the magnetic field direction in the first radially magnetized permanent magnet 1310 or the magnetic field direction in the second radially magnetized permanent magnet 1330. That is, an included angle between the magnetic field direction in the first radially magnetized permanent magnet 1310 and the surface is 0 degrees, an included angle between the magnetic field direction in the axially magnetized permanent magnet 1320 and the surface is 90 degrees, and an included angle between the magnetic field direction in the second radially magnetized permanent magnet 1330 and the surface is 0 degrees. An included angle between the magnetic field direction in the axially magnetized permanent magnet 1320 and the magnetic field direction in the first radially magnetized permanent magnet 1310 or the magnetic field direction in the second radially magnetized permanent magnet 1330 is 90 degrees. In another embodiment, an included angle between the magnetic field direction in the first radially magnetized permanent magnet 1310 and the surface may be greater than 0 degrees, an included angle between the magnetic field direction in the axially magnetized permanent magnet 1320 and the surface may be less than 90 degrees, and an included angle between the magnetic field direction in the second radially magnetized permanent magnet 1330 and the surface may be greater than 0 degrees. An included angle between the magnetic field direction in the axially magnetized permanent magnet 1320 and the magnetic field direction in the first radially magnetized permanent magnet 1310 or the magnetic field direction in the second radially magnetized permanent magnet 1330 may be less than 90 degrees.

In this embodiment of this application, in the magnetic alignment apparatus 1300, the magnetic field direction of the first axially magnetized permanent magnet 1310 is opposite to the magnetic field direction of the second axially magnetized permanent magnet 1330. In an embodiment, an included angle between the magnetic field direction of the first axially magnetized permanent magnet 1310 and the magnetic field direction of the second axially magnetized permanent magnet 1330 is 180 degrees. In another embodiment, an included angle between the magnetic field direction of the first axially magnetized permanent magnet 1310 and the magnetic field direction of the second axially magnetized permanent magnet 1330 may be less than 180 degrees.

The magnetic alignment apparatus 1300 provided in this embodiment of this application is similar to the magnetic alignment apparatus 900, and the upper side and the lower side of the magnetic alignment apparatus 1300 are symmetrical. That is, magnetic field strength on one side of the magnetic alignment apparatus 1300 is enhanced, and magnetic field strength on the other side of the magnetic alignment apparatus 1300 is reduced. The magnetic field strength on the one side of the magnetic alignment apparatus 1300 is different from the magnetic field strength on the other side of the magnetic alignment apparatus 1300. The magnetic field strength on the one side of the magnetic alignment apparatus 1300 is stronger than the magnetic field strength on the other side of the magnetic alignment apparatus 1300.

The magnetic alignment apparatus 1300 provided in this embodiment of this application is similar to the magnetic alignment apparatus 900, and the magnetic alignment apparatus 1300 may also be used in the wireless charging module 10 shown in FIG. 2. Correspondingly, the charging coil 20 of the wireless charging module 10 may be disposed on an inner side or an outer side of the magnetic alignment apparatus 1300.

In an embodiment of this application, the magnetic alignment apparatus of the wireless charging module includes a first permanent magnet and a second permanent magnet, and the first permanent magnet and the second permanent magnet are disposed adjacently on one surface. A magnetization manner for the first permanent magnet is different from a magnetization manner for the second permanent magnet.

In an embodiment, the magnetization manner for the first permanent magnet is radial magnetization, and the magnetization manner for the second permanent magnet is axial magnetization.

In an embodiment, a magnetic field direction in the first permanent magnet is parallel to the surface, and a magnetic field direction in the second permanent magnet is perpendicular to the surface.

In an embodiment of this application, the magnetic alignment apparatus of the wireless charging module includes a first permanent magnet, a second permanent magnet, and a third permanent magnet. The first permanent magnet, the second permanent magnet, and the third permanent magnet are disposed adjacently on one surface in sequence. A magnetization manner for the first permanent magnet is different from a magnetization manner for the second permanent magnet. A magnetization manner for the third permanent magnet is the same as the magnetization manner for the first permanent magnet. A magnetic field direction in the third permanent magnet is opposite to a magnetic field direction in the first permanent magnet.

In an embodiment, the magnetization manner for the first permanent magnet is radial magnetization, the magnetization manner for the second permanent magnet is axial magnetization, and the magnetization manner for the third permanent magnet is radial magnetization.

In an embodiment, a magnetic field direction in the first permanent magnet is parallel to the surface, a magnetic field direction in the second permanent magnet is perpendicular to the surface, and a magnetic field direction in the third permanent magnet is parallel to the surface.

FIG. 15 is a schematic diagram of a structure of a permanent magnet of a magnetic alignment apparatus according to an embodiment of this application. As shown in FIG. 15, the axially magnetized permanent magnet 310 of the magnetic alignment apparatus 300 includes only one cylindrical permanent magnet module. The radially magnetized permanent magnet 320 includes a plurality of permanent magnet modules, and the plurality of permanent magnet modules are spliced into a ring-shaped cylindrical structure. In this embodiment, top-view cross-sectional shapes of the plurality of permanent magnet modules in the radially magnetized permanent magnet 320 are arc shapes. The permanent magnet module may be a fan-shaped magnet with an angle of 360°/M. M is a quantity of permanent magnet modules spliced into a permanent magnet in a circular ring shape, and is greater than or equal to 2. In some embodiments, a top-view cross-sectional shape of the permanent magnet module may be alternatively a polygonal shape, for example, a triangular shape or a quadrangular shape. Based on internal space of the electronic device 100 and the charger 200, permanent magnet modules in a plurality of shapes may be selected for the magnetic alignment apparatus 300, thereby improving applicability of the magnetic alignment apparatus 300.

In some embodiments, the axially magnetized permanent magnet 310 of the magnetic alignment apparatus 300 may include a plurality of permanent magnet modules, and the plurality of permanent magnet modules are spliced into a cylindrical structure. In some embodiments, the radially magnetized permanent magnet 320 of the magnetic alignment apparatus 300 may include only one ring-shaped cylindrical permanent magnet module. In some embodiments, the axially magnetized permanent magnet 310 and the radially magnetized permanent magnet 320 of the magnetic alignment apparatus 300 each include a plurality of permanent magnet modules. That is, a plurality of permanent magnets in the magnetic alignment apparatus 300 each may include one or more permanent magnet modules. It can be understood that the magnetic alignment apparatus 500 shown in FIG. 5 is similar to the magnetic alignment apparatus 300, and a plurality of permanent magnets of the magnetic alignment apparatus 500 each may also include a plurality of permanent magnet modules.

FIG. 16 is a schematic diagram of a structure of a permanent magnet of another magnetic alignment apparatus according to an embodiment of this application. As shown in FIG. 16, the first axially magnetized permanent magnet 910, the radially magnetized permanent magnet 920, and the second axially magnetized permanent magnet 930 of the magnetic alignment apparatus 900 each include a plurality of permanent magnet modules. The plurality of permanent magnet modules are spliced into a ring-shaped structure. In another embodiment, one or more of the first axially magnetized permanent magnet 910, the radially magnetized permanent magnet 920, and the second axially magnetized permanent magnet 930 may include only one ring-shaped cylindrical permanent magnet module. The plurality of permanent magnet modules are spliced into a ring-shaped structure. That is, a plurality of permanent magnets in the magnetic alignment apparatus 900 each may include one or more permanent magnet modules. It can be understood that the magnetic alignment apparatus 700 shown in FIG. 7 or the magnetic alignment apparatus 1300 shown in FIG. 13 is similar to the magnetic alignment apparatus 900, and a plurality of permanent magnets in the magnetic alignment apparatus 700 or the magnetic alignment apparatus 1300 each may also include one or more permanent magnet modules.

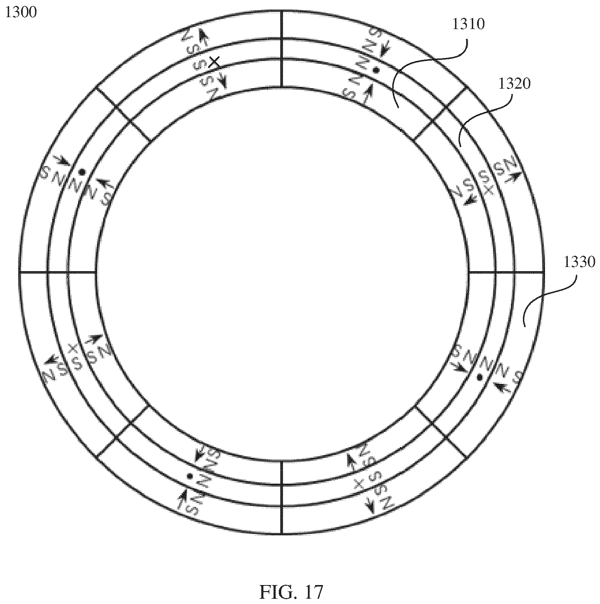

FIG. 17 is a schematic diagram of a magnetic field of a permanent magnet of another magnetic alignment apparatus according to an embodiment of this application. The first radially magnetized permanent magnet 1310, the axially magnetized permanent magnet 1320, and the second radially magnetized permanent magnet 1330 of the magnetic alignment apparatus 1300 each include a plurality of permanent magnet modules. The plurality of permanent magnet modules are spliced into a ring-shaped structure.

As shown in FIG. 17, magnetization manners for a plurality of permanent magnet modules in the first radially magnetized permanent magnet 1310 are the same, magnetization manners for a plurality of permanent magnet modules in the axially magnetized permanent magnet 1320 are the same, and magnetization manners for a plurality of permanent magnet modules in the second radially magnetized permanent magnet 1330 are the same. That is, magnetization manners for a plurality of permanent magnet modules of one permanent magnet are the same.

As shown in FIG. 17, magnetic field directions in two adjacent permanent magnet modules in the first radially magnetized permanent magnet 1310 are opposite, magnetic field directions in two adjacent permanent magnet modules in the axially magnetized permanent magnet 1320 are opposite, and magnetic field directions in two adjacent permanent magnet modules in the second radially magnetized permanent magnet 1330 are opposite. For example, an N pole of one of two adjacent permanent magnet modules in the first radially magnetized permanent magnet 1310 faces an inner side of the first radially magnetized permanent magnet 1310, and an S pole faces an outer side of the first radially magnetized permanent magnet 1310; and an S pole of the other one of the two adjacent permanent magnet modules in the first radially magnetized permanent magnet 1310 faces the inner side of the first radially magnetized permanent magnet 1310, and an N pole faces the outer side of the first radially magnetized permanent magnet 1310. That is, magnetic field directions in two adjacent permanent magnet modules of a plurality of permanent magnet modules in one permanent magnet are opposite. This can reduce a repulsive force between permanent magnet modules in an assembly process of the magnetic alignment apparatus 900, thereby facilitating assembly of the magnetic alignment apparatus 900.

In another embodiment, a plurality of permanent magnet modules in one permanent magnet may be divided into at least two sides, and magnetic field directions in a plurality of permanent magnet modules on one side of the plurality of permanent magnet modules on two adjacent sides are opposite to magnetic field directions in a plurality of permanent magnet modules on the other side. For example, M permanent magnet modules in one permanent magnet are divided into two sides, where M1 permanent magnet modules are included on one side, and M2 permanent magnet modules are included on the other side. M is a positive integer greater than or equal to 2, and M = M1 + M2. S poles in the M1 permanent magnet modules on the one side face upward, and N poles face downward. S poles in the M2 permanent magnet modules on the other side face downward, and N poles face upward. That is, magnetic field directions in a plurality of permanent magnet modules on one side of a plurality of permanent magnet modules on two adjacent sides in one permanent magnet are opposite to magnetic field directions in a plurality of permanent magnet modules on the other side. This can reduce a repulsive force between permanent magnet modules in an assembly process of the magnetic alignment apparatus, thereby facilitating assembly of the magnetic alignment apparatus.

A first permanent magnet, a second permanent magnet, or a third permanent magnet of the magnetic alignment apparatus in the wireless charging module provided in this embodiment of this application may include one or more permanent magnet modules.

In an embodiment, the first permanent magnet, the second magnetized permanent magnet, or the third permanent magnet may include a plurality of permanent magnet modules, and magnetization manners for a plurality of permanent magnets in one permanent magnet are the same.

In an embodiment, the first permanent magnet, the second magnetized permanent magnet, or the third permanent magnet may include a plurality of permanent magnet modules, and internal magnetic field directions of two adjacent permanent magnets in one permanent magnet are opposite.

In an embodiment, the first permanent magnet, the second magnetized permanent magnet, or the third permanent magnet may include a plurality of permanent magnet modules, a plurality of permanent magnet modules in one permanent magnet are divided into at least two sides, and internal magnetic field directions of permanent magnets on two adjacent sides are opposite.

In an embodiment, a top-view cross-sectional shape of the permanent magnet module is an arc shape or a polygonal shape.

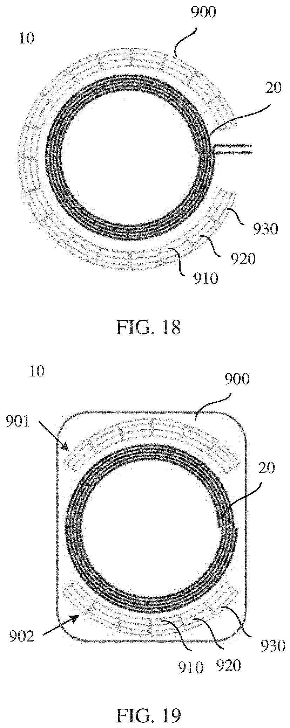

FIG. 18 is a schematic diagram of a top-view cross-section of a wireless charging module according to an embodiment of this application. As shown in FIG. 18, the wireless charging module 10 includes a charging coil 20 and a magnetic alignment apparatus 900. A top-view cross-sectional shape of the magnetic alignment apparatus 900 is an arc shape. In an embodiment, the magnetic alignment apparatus 900 includes a first permanent magnet 910 and a second permanent magnet 920. Correspondingly, top-view cross-sectional shapes of the first permanent magnet 910 and the second permanent magnet 920 are arc shapes. In an embodiment, the magnetic alignment apparatus 900 includes a first permanent magnet 910, a second permanent magnet 920, and a third permanent magnet 930. Correspondingly, top-view cross-sectional shapes of the first permanent magnet 910, the second permanent magnet 920, and the third permanent magnet 930 are arc shapes. That is, the top-view cross-sectional shape of the magnetic alignment apparatus 900 is a ring shape with one notch, and the top-view cross-sectional shapes of the first permanent magnet 910, the second permanent magnet 920, and the third permanent magnet 930 are ring shapes that each have one notch. For a magnetization manner and an internal magnetic field direction of the first permanent magnet 910, the second permanent magnet 920, or the third permanent magnet 930, refer to other embodiments of this application. Descriptions are not repeated.

In this embodiment, the first permanent magnet 910, the second permanent magnet 920, or the third permanent magnet 930 includes a plurality of permanent magnet modules. The plurality of permanent magnet modules are spliced into an arc shape. In another embodiment, the first permanent magnet 910, the second permanent magnet 920, or the third axially magnetized permanent magnet 930 includes one permanent magnet module. A top-view cross-sectional shape of the permanent magnet module is an arc shape.

As shown in FIG. 18, the charging coil 20 of the wireless charging module 10 is disposed on an inner side of the magnetic alignment apparatus 900, and another device of the electronic device 100 or the charger 200 may be disposed on an outer side of the magnetic alignment apparatus 900. Correspondingly, the charging coil 20 of the wireless charging module 10 may be electrically connected to the another device on the outer side of the magnetic alignment apparatus 900 through the notch of the magnetic alignment apparatus 900. This helps improve miniaturization of the electronic device 100 or the charger 200. In another embodiment, alternatively, the charging coil 20 of the wireless charging module 10 may be disposed on an outer side of the magnetic alignment apparatus 900, and another device of the electronic device 100 or the charger 200 may be disposed on an inner side of the magnetic alignment apparatus 900. Correspondingly, the charging coil 20 of the wireless charging module 10 may be electrically connected to the another device on the inner side of the magnetic alignment apparatus 900 through the notch of the magnetic alignment apparatus 900. This helps improve miniaturization of the electronic device 100 or the charger 200.

FIG. 19 is a schematic diagram of a top-view cross-sectional shape of another wireless charging module according to an embodiment of this application. As shown in FIG. 19, the wireless charging module 10 includes a charging coil 20 and a magnetic alignment apparatus 900. The magnetic alignment apparatus 900 includes a first group of permanent magnets 901 and a second group of permanent magnets 902. The first group of permanent magnets 901 and the second group of permanent magnets 902 are disposed on one surface. Spacings between the first group of permanent magnets 901 and the second group of permanent magnets 902 constitute two notches of a ring-shaped structure of the magnetic alignment apparatus 900. The first group of permanent magnets 901 and the second group of permanent magnets 902 each include a first permanent magnet 910, a second permanent magnet 920, and a third permanent magnet 930 that are disposed adjacently. For a magnetization manner and an internal magnetic field direction of the first permanent magnet 910, the second permanent magnet 920, or the third permanent magnet 930, refer to other embodiments of this application. Descriptions are not repeated.

As shown in FIG. 19, top-view cross-sectional shapes of the first group of permanent magnets 901 and the second group of permanent magnets 902 are arc shapes. The first group of permanent magnets 901 and the second group of permanent magnets 902 constitute some arcs of the ring-shaped structure of the magnetic alignment apparatus 900. In this embodiment, the first axial permanent magnet 910, the second magnetized permanent magnet 920, and the third magnetized permanent magnet 930 each include a plurality of permanent magnet modules. The plurality of permanent magnet modules are spliced into an arc shape. A top-view cross-sectional shape of the permanent magnet module may include an arc shape or a polygonal shape. A magnetization manner for the permanent magnet module may include axial magnetization or radial magnetization. In another embodiment, the first axial permanent magnet 910, the second magnetized permanent magnet 920, or the third magnetized permanent magnet 930 may include one permanent magnet module. A top-view cross-sectional shape of the permanent magnet module is an arc shape. A magnetization manner for the permanent magnet module may include axial magnetization or radial magnetization.

In the magnetic alignment apparatus 900 shown in FIG. 19, an internal magnetic field direction of an axially magnetized permanent magnet in the first group of permanent magnets 901 and an internal magnetic field direction of an axially magnetized permanent magnet in the second group of permanent magnets 902 may be the same or opposite. For example, a magnetization manner for a first permanent magnet 910 in the first group of permanent magnets 901 is axial magnetization, and a magnetization manner for a first permanent magnet 910 in the second group of permanent magnets 901 is axial magnetization. An internal magnetic field direction of the first permanent magnet 910 in the first group of permanent magnets 901 points from an upper side to a lower side. An internal magnetic field direction of the first permanent magnet 910 in the second group of permanent magnets 901 points from a lower side to an upper side. Correspondingly, the magnetic alignment apparatus 900 shown in FIG. 19 may be used in the wireless charging module 10 of the electronic device 100 or the charger 200. During wireless charging, the magnetic alignment apparatus 900 not only can be configured to limit a contact location between the electronic device 100 and the charger 200, but also can be configured to limit relative orientations of the electronic device 100 and the charger 200.

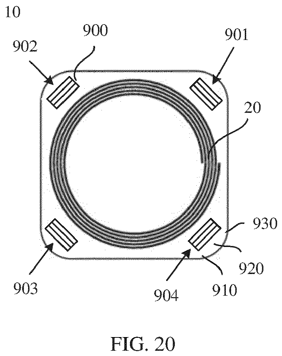

FIG. 20 is a schematic diagram of a top-view cross-sectional shape of another wireless charging module according to an embodiment of this application. As shown in FIG. 20, the wireless charging module 10 includes a charging coil 20 and a magnetic alignment apparatus 900. The magnetic alignment apparatus 900 includes a first group of permanent magnets 901, a second group of permanent magnets 902, a third group of permanent magnets 903, and a fourth group of permanent magnets 904. The first group of permanent magnets 901, the second group of permanent magnets 902, the third group of permanent magnets 903, and the fourth group of permanent magnets 904 are disposed on one surface. The first group of permanent magnets 901, the second group of permanent magnets 902, the third group of permanent magnets 903, and the fourth group of permanent magnets 904 each constitute a part of a ring-shaped structure. Spacings between the first group of permanent magnets 901, the second group of permanent magnets 902, the third group of permanent magnets 903, and the fourth group of permanent magnets 904 may constitute four notches of the ring-shaped structure. The first group of permanent magnets 901, the second group of permanent magnets 902, the third group of permanent magnets 903, and the fourth group of permanent magnets 904 each include a first permanent magnet 910, a second permanent magnet 920, and a third permanent magnet 930 that are disposed adjacently. For a magnetization manner and an internal magnetic field direction of the first permanent magnet 910, the second permanent magnet 920, or the third permanent magnet 930, refer to other embodiments of this application. Descriptions are not repeated.

As shown in FIG. 20, top-view cross-sectional shapes of the first group of permanent magnets 901, the second group of permanent magnets 902, the third group of permanent magnets 903, and the fourth group of permanent magnets 904 may be rectangular shapes. The first group of permanent magnets 901, the second group of permanent magnets 902, the third group of permanent magnets 903, and the fourth group of permanent magnets 904 each constitute some edges of a polygonal ring-shaped structure of the magnetic alignment apparatus 900. In this embodiment, the first permanent magnet 910, the second permanent magnet 920, and the third permanent magnet 930 each include only one permanent magnet module. A top-view cross-sectional shape of the permanent magnet module is a rectangular shape. A magnetization manner for the permanent magnet module may include axial magnetization or radial magnetization. In another embodiment, the first permanent magnet 910, the second permanent magnet 920, and the third permanent magnet 930 each may include a plurality of permanent magnet modules. The plurality of permanent magnet modules are spliced into a rectangular shape. A top-view cross-sectional shape of the permanent magnet module includes a polygonal shape, for example, a triangular shape or a quadrangular shape. A magnetization manner for the permanent magnet module may include axial magnetization or radial magnetization. For example, a magnetization manner for one or more permanent magnet modules in the first permanent magnet 910 is radial magnetization, a magnetization manner for one or more permanent magnet modules in the second permanent magnet 920 is axial magnetization, and a magnetization manner for one or more permanent magnet modules in the second permanent magnet 920 is radial magnetization.

In another embodiment, the top-view cross-sectional shape of the first group of permanent magnets 901, the second group of permanent magnets 902, the third group of permanent magnets 903, or the fourth group of permanent magnets 904 may be alternatively a triangular shape, a quadrangular shape, or another polygonal shape. A top-view cross-sectional shape of one or more permanent magnet modules in the first permanent magnet 910, the second permanent magnet 920, or the third permanent magnet 930 may be alternatively a triangular shape, a quadrangular shape, or another polygonal shape.

In the magnetic alignment apparatus 900 shown in FIG. 20, an internal magnetic field direction of an axially magnetized permanent magnet in the first group of permanent magnets 901, an internal magnetic field direction of an axially magnetized permanent magnet in the second group of permanent magnets 902, an internal magnetic field direction of an axially magnetized permanent magnet in the third group of permanent magnets 903, and an internal magnetic field direction of an axially magnetized permanent magnet in the fourth group of permanent magnets 904 may be all the same, or some of the internal magnetic field directions may be opposite. For example, a magnetization manner for a first permanent magnet 910 in the first group of permanent magnets 901 is axial magnetization, and a magnetization manner for a first permanent magnet 910 in the third group of permanent magnets 903 is axial magnetization. An internal magnetic field direction of the first permanent magnet 910 in the first group of permanent magnets 901 points from an upper side to a lower side. An internal magnetic field direction of the first permanent magnet 910 in the third group of permanent magnets 903 points from a lower side to an upper side. Correspondingly, the magnetic alignment apparatus 900 shown in FIG. 20 may be used in the wireless charging module 10 of the electronic device 100 or the charger 200. During wireless charging, the magnetic alignment apparatus 900 not only can be configured to limit a contact location between the electronic device 100 and the charger 200, but also can be configured to limit relative orientations of the electronic device 100 and the charger 200.

In this embodiment of this application, a top-view cross-sectional shape of the magnetic alignment apparatus is a ring shape with a plurality of notches. The ring shape includes a circular ring shape, a polygonal ring shape, or the like. The magnetic alignment apparatus may include a plurality of magnetic alignment modules. Each magnetic alignment module includes a group of permanent magnets. Each group of permanent magnets includes a plurality of permanent magnets that are disposed adjacently. The plurality of magnetic alignment modules are disposed on one surface. The plurality of magnetic alignment modules each may constitute a part of a ring-shaped structure. A spacing between two adjacent magnetic alignment modules constitutes a notch of the ring-shaped structure. The charging coil of the wireless charging module may be electrically connected to another device through the notch. This helps improve miniaturization of the electronic device or the charger.

In this embodiment of this application, the magnetic alignment apparatus may include a plurality of groups of permanent magnets, and each group of permanent magnets includes a plurality of permanent magnets that are disposed adjacently. Each permanent magnet may include one or more permanent magnet modules. Magnetization manners for a plurality of permanent magnet modules of each permanent magnet are the same. The plurality of groups of permanent magnets are disposed on one surface, and each group of permanent magnets constitutes a part of a ring-shaped structure.

In an embodiment, there is a spacing between two adjacent groups of permanent magnets in the magnetic alignment apparatus, and the spacing may constitute a notch of the ring-shaped structure. The charging coil of the wireless charging module may be electrically connected to another device through the notch. This helps improve miniaturization of the electronic device or the charger.

In an embodiment, a top-view cross-sectional shape of each group of permanent magnets is an arc shape or a polygonal shape.

In an embodiment, each group of permanent magnets includes a first permanent magnet and a second magnetized permanent magnet that are disposed adjacently. A top-view cross-sectional shape of the first permanent magnet or the second magnetized permanent magnet is an arc shape or a polygonal shape.

In an embodiment, each group of permanent magnets includes a first permanent magnet, a second magnetized permanent magnet, and a third permanent magnet that are disposed adjacently. A top-view cross-sectional shape of the first permanent magnet, the second magnetized permanent magnet, or the third permanent magnet is an arc shape or a polygonal shape.

In an embodiment, the first permanent magnet, the second magnetized permanent magnet, or the third permanent magnet includes one or more permanent magnet modules. A top-view cross-sectional shape of the permanent magnet module is an arc shape or a polygonal shape.

In an embodiment, the magnetic alignment apparatus may include a plurality of groups of permanent magnets. An internal magnetic field direction of an axially magnetized permanent magnet in a group of permanent magnets and an internal magnetic field direction of an axially magnetized permanent magnet in another group of permanent magnets may be opposite.

A location relationship, a quantity, a magnetization manner, a top-view cross-sectional shape, an internal magnetic field direction, a structure, and the like of permanent magnets in the magnetic alignment apparatus of the wireless charging module provided in this embodiment of this application are not limited to the foregoing embodiments. All technical solutions implemented without departing from the principles of this application fall within the protection scope of this solution. Any technical solutions obtained by properly combining one or more embodiments or drawings in the specification fall within the protection scope of this solution.

Finally, it is noted that the foregoing embodiments are merely intended to describe technical solutions of this application. Persons of ordinary skill in the art should understand that, although this application is described in detail with reference to the foregoing embodiments, they may still make modifications to technical solutions described in the foregoing embodiments or make equivalent replacements to some technical features of technical solutions described in the foregoing embodiments. However, these modifications or replacements do not make the essence of corresponding technical solutions depart from the scope of technical solutions in embodiments of this application.

## Claims

1. A wireless charging module, comprising:
a magnetic alignment apparatus, comprising a first permanent magnet and a second permanent magnet, wherein the first permanent magnet and the second permanent magnet are disposed adjacently on one surface, magnetization manners for the first permanent magnet and the second permanent magnet are different, and magnetic field strength on an upper side and a lower side of the magnetic alignment apparatus is different; and
a charging coil, configured to receive or transmit electricity, wherein the charging coil is disposed on an inner side or an outer side of the magnetic alignment apparatus.

2. The wireless charging module according to claim 1, wherein the magnetization manners for the first permanent magnet and the second permanent magnet comprise axial magnetization and radial magnetization, or the magnetization manners for the first permanent magnet and the second permanent magnet comprise axial magnetization and radial magnetization.

3. The wireless charging module according to claim 1, wherein a magnetic field direction in the first permanent magnet is perpendicular to the surface, and a magnetic field direction in the second permanent magnet is parallel to the surface; or a magnetic field direction in the first permanent magnet is parallel to the surface, and a magnetic field direction in the second permanent magnet is perpendicular to the surface.

4. The wireless charging module according to any one of claims 1 to 3, wherein a top-view cross-sectional shape of the first permanent magnet is one of a circular shape, a ring shape, an arc shape, or a polygonal shape, and a top-view cross-sectional shape of the second permanent magnet is one of a ring shape, an arc shape, or a polygonal shape.

5. The wireless charging module according to any one of claims 1 to 4, wherein the magnetic alignment apparatus comprises a third permanent magnet, a magnetization manner for the third permanent magnet is the same as a magnetization manner for the first permanent magnet, a magnetic field direction in the third permanent magnet is opposite to a magnetic field direction in the first permanent magnet, the third permanent magnet and the second permanent magnet are disposed adjacently on the surface, and the charging coil is disposed on an inner side of the first permanent magnet or an outer side of the third permanent magnet.

6. The wireless charging module according to claim 5, wherein a top-view cross-sectional shape of the third permanent magnet is one of a ring shape, an arc shape, or a polygonal shape.

7. The wireless charging module according to any one of claims 1 to 6, wherein the first permanent magnet, the second permanent magnet, or the third permanent magnet comprises one or more permanent magnet modules, and magnetization manners for permanent magnet modules of a same permanent magnet are the same.

8. The wireless charging module according to claim 7, wherein magnetic field directions in two adjacent permanent magnet modules in one permanent magnet are opposite; or a plurality of permanent magnet modules in one permanent magnet comprise at least two sides, and a magnetic field direction in a plurality of permanent magnet modules on one side of two adjacent sides is opposite to a magnetic field direction in a plurality of permanent magnet modules on the other side.

9. An electronic device, comprising a power module and the wireless charging module according to any one of claims 1 to 8, wherein a charging coil of the wireless charging module is electrically connected to the power module, the charging coil of the wireless charging module is configured to receive electric energy transmitted by the charging coil of a charger, magnetic field strength on an upper side of a magnetic alignment apparatus is weaker than magnetic field strength on a lower side of the magnetic alignment apparatus, and the magnetic alignment apparatus is configured to limit a contact location between the electronic device and the charger, so that the charging coil of the charger matches the charging coil of the electronic device.

10. A charger, comprising a power module and the wireless charging module according to any one of claims 1 to 8, wherein a charging coil of the wireless charging module is electrically connected to the power module, the charging coil of the wireless charging module is configured to transmit electric energy to a charging coil of an electronic device, magnetic field strength on an upper side of a magnetic alignment apparatus is stronger than magnetic field strength on a lower side of the magnetic alignment apparatus, and the magnetic alignment apparatus is configured to limit a contact location between the charger and the electronic device, so that the charging coil of the charger matches the charging coil of the electronic device.
